# EUROPEAN PATENT SPECIFICATION

(11) **EP 4 404 026 B1**
(45) Date of publication and mention of the grant of the patent: **26.11.2025**
(21) Application number: 22887529.0
(22) Date of filing: 24.10.2022
(51) Int. Cl.: G06F 1/16, H04M 1/02

(54) **ELECTRONIC APPARATUS INCLUDING FLEXIBLE DISPLAY**
ELEKTRONISCHE VORRICHTUNG MIT FLEXIBLER ANZEIGE
APPAREIL ÉLECTRONIQUE COMPRENANT UN ÉCRAN SOUPLE

(30) Priority: 25.10.2021 KR 20210142981
(43) Date of publication of application: 24.07.2024
(73) Proprietor: Samsung Electronics Co., Ltd., Suwon-si, Gyeonggi-do 16677 (KR)
(72) Inventor: KANG, Hyunggwang, Suwon-si Gyeonggi-do 16677 (KR); JUNG, Hojin, Suwon-si Gyeonggi-do 16677 (KR); KWAK, Myunghoon, Suwon-si Gyeonggi-do 16677 (KR); KIM, Junhyuk, Suwon-si Gyeonggi-do 16677 (KR); JEONG, Hoyoung, Suwon-si Gyeonggi-do 16677 (KR); CHO, Hyoungtak, Suwon-si Gyeonggi-do 16677 (KR); HONG, Hyunju, Suwon-si Gyeonggi-do 16677 (KR)
(74) Representative: Gulde & Partner
(86) International application number: PCT/KR2022/016276
(87) International publication number: WO 2023/075333

(56) References cited:
- WO-A1-2021/075608
- WO-A1-2021/182740
- CN-A- 111 182 090
- CN-A- 113 419 568
- KR-A- 20190 143 029
- KR-B1- 102 290 231
- US-A1- 2012 026 664
- US-A1- 2021 382 526
- US-A1- 2022 335 869

## Description

### BACKGROUND

### 1. Field

The disclosure relates to an electronic device including a flexible display.

### 2. Description of Related Art

An electronic device may include a flexible display. The electronic device may extend a display region visually exposed on an outer surface of the electronic device. For example, a flexible display may be disposed in the electronic device in a curved, foldable, or rollable form.

Conventional devices are known from WO 2021/182740 A1.

### SUMMARY

A slidable electronic device may automatically extend or reduce the electronic device by driving a motor. The electronic device may track the extended state of the electronic device based on the number of revolutions of the motor, or may estimate the extended state of the electronic device using a magnet and a Hall sensor. In this case, accuracy may be decreased, and errors may occur.

Aspects of the disclosure are to address at least the above-mentioned problems and/or disadvantages and to provide at least the advantages described below. Accordingly, an aspect of the disclosure is to provide an electronic device for accurately determining a state of the electronic device by sensing contact between sensing pads disposed at positions corresponding to states of the electronic device and a conductive member.

In accordance with an aspect of the disclosure, an electronic device is provided. The electronic device includes a first housing, a second housing coupled to the first housing so as to slide in a first direction and a second direction opposite to the first direction, a flexible display including an exposed region that is exposed on a front surface of the electronic device and varied in size in response to sliding of the second housing, a sensing substrate disposed in the first housing, and a conductive roller disposed in the second housing so as to be rotatable. A plurality of sensing pads are disposed on one surface of the sensing substrate. The conductive roller is configured to make contact with a part of the plurality of sensing pads as the second housing slides relative to the first housing. The plurality of sensing pads include a plurality of position pads that make contact with the conductive roller in a state in which the exposed region of the flexible display is formed in one or more specified sizes.

In accordance with an aspect of the disclosure, one or more non-transitory computer-readable storage media storing one or more computer programs including computer-executable instructions that, when executed by one or more processors of an electronic device, cause the electronic device to perform operations are provided. The operations include sensing contact between a conductive roller and a plurality of position pads, determining a position of the conductive roller based on a signal recognized by a contact and a change in a signal, comparing expected time it takes the conductive roller to make contact with an adjacent pre-position pad corresponding to a target pad and contact time spent in actual contact, compensating for a moving distance by difference by controlling driving of a motor when a difference between the expected time and the contact time is within a first range, and driving in an abnormal case when the difference between the expected time and the contact time exceeds the first range.

The electronic device according to the various embodiments of the disclosure accurately determines the state of the electronic device by sensing the contact between the sensing pads disposed at the positions corresponding to the states of the electronic device and the conductive member.

Other aspects, advantages, and salient features of the disclosure will become apparent to those skilled in the art from the following detailed description, which, taken in conjunction with the annexed drawings, discloses various embodiments of the disclosure.

### BRIEF DESCRIPTION OF THE DRAWINGS

FIG. 1 is a block diagram of an electronic device in a network environment according to an embodiment of the disclosure;
FIG. 2 is a view illustrating a first state and a second state of an electronic device according to an embodiment of the disclosure;
FIG. 3 is an exploded perspective view of an electronic device according to an embodiment of the disclosure;
FIG. 4 is a sectional view of an electronic device according to an embodiment of the disclosure;
FIG. 5 is a view illustrating a first support member of an electronic device according to an embodiment of the disclosure;
FIG. 6 is a view illustrating a first support member of an electronic device according to an embodiment of the disclosure;
FIG. 7 is a view illustrating a second support member of an electronic device according to an embodiment of the disclosure;
FIG. 8 is a view illustrating a second support member of an electronic device according to an embodiment of the disclosure;
FIG. 9A is a view illustrating a conductive member of an electronic device according to an embodiment of the disclosure;
FIG. 9B is a view illustrating a portion of a second support member of an electronic device according to an embodiment of the disclosure;
FIG. 10 is a view illustrating a first support member and a second support member of an electronic device according to an embodiment of the disclosure;
FIG. 11 is a view illustrating a contact structure between a sensing substrate and a conductive member of an electronic device according to an embodiment of the disclosure;
FIG. 12 is a view illustrating a sensing substrate and sensing pads of an electronic device according to an embodiment of the disclosure;
FIG. 13 is a view illustrating a contact structure between sensing pads and a conductive member of an electronic device according to an embodiment of the disclosure;
FIG. 14 a view illustrating an operation in which a state of an electronic device is changed according to an embodiment of the disclosure;
FIG. 15 is a view illustrating positions of sensing pads corresponding to states of an electronic device according to an embodiment of the disclosure;
FIG. 16 is a view illustrating a circuit configuration of sensing pads of an electronic device according to an embodiment of the disclosure;
FIG. 17 is a flowchart illustrating an operating method of an electronic device according to an embodiment of the disclosure;
FIG. 18 is a flowchart illustrating an operating method of an electronic device according to an embodiment of the disclosure;
FIG. 19 is a flowchart illustrating an operating method of an electronic device according to an embodiment of the disclosure; and
FIG. 20 is a view illustrating an operation in which a conductive member moves in response to a change of state of an electronic device according to an embodiment of the disclosure.

Throughout the drawings, like reference numerals will be understood to refer to like parts, components, and structures.

### DETAILED DESCRIPTION

The following description with reference to the accompanying drawings is provided to assist in a comprehensive understanding of various embodiments of the disclosure as defined by the claims. It includes various specific details to assist in that understanding but these are to be regarded as merely exemplary. Accordingly, those of ordinary skill in the art will recognize that various changes and modifications of the various embodiments described herein can be made without departing from the scope of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims.

It is to be understood that the singular forms "a," "an," and "the" include plural referents unless the context clearly dictates otherwise. Thus, for example, reference to "a component surface" includes reference to one or more of such surfaces.

It should be appreciated that the blocks in each flowchart and combinations of the flowcharts may be performed by one or more computer programs which include instructions. The entirety of the one or more computer programs may be stored in a single memory or the one or more computer programs may be divided with different portions stored in different multiple memories.

Any of the functions or operations described herein can be processed by one processor or a combination of processors. The one processor or the combination of processors is circuitry performing processing and includes circuitry like an application processor (AP, e.g. a central processing unit (CPU)), a communication processor (CP, e.g., a modem), a graphics processing unit (GPU), a neural processing unit (NPU) (e.g., a near field communication (NFC) chip, connectivity chips, a sensor controller, a touch controller, a finger-print sensor controller, a display drive integrated circuit (IC), an audio CODEC chip, a universal serial bus (USB) controller, a camera controller, an image processing IC, a microprocessor unit (MPU), a system on chip (SoC), an integrated circuit (IC), or the like.

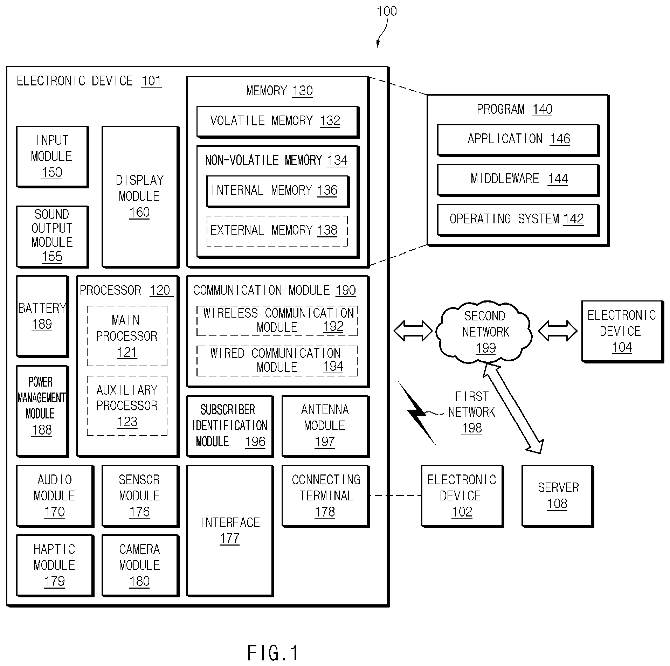

FIG. 1 is a block diagram illustrating an electronic device 101 in a network environment 100 according to an embodiment of the disclosure.

Referring to FIG. 1, an electronic device 101 in a network environment 100 may communicate with an electronic device 102 via a first network 198 (e.g., a short-range wireless communication network), or an electronic device 104 or a server 108 via a second network 199 (e.g., a long-range wireless communication network). In an embodiment, the electronic device 101 may communicate with the electronic device 104 via the server 108. According to another embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added in the electronic device 101. In some embodiments, some of the components may be implemented as single integrated circuitry. In an example, some (e.g., the sensor module 176, the camera module 180, or the antenna module 197) of the components may be implemented as embedded in the display module 160 (e.g., a display).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may load a command or data received from another component (e.g., the sensor module 176 or the communication module 190) in a volatile memory 132, process the command or the data stored in the volatile memory 132, and store resulting data in a non-volatile memory 134. According to another embodiment, the processor 120 may include a main processor 121 (e.g., a central processing unit (CPU) or an application processor (AP)), and an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. When the electronic device 101 includes the main processor 121 and the auxiliary processor, the auxiliary processor 123 may be adapted to consume less power than the main processor 121, or to be specific to a specified function. The auxiliary processor 123 may be implemented as separate from, or as part of the main processor 121.

The auxiliary processor 123 may, for example, control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to another embodiment, the auxiliary processor 123 (e.g., a neural network processing device) may include a hardware structure specified for processing an artificial intelligence (AI) model. The AI model may be generated through machine learning. The learning may be performed by the electronic device 101 performing the AI, and may be performed through an additional server (e.g., the server 108). A learning algorithm may include, for example, a supervised learning algorithm, an unsupervised learning algorithm, a semi-supervised learning algorithm, or a reinforcement learning algorithm, but the disclosure is not limited thereto. The AI model may, for example, include a plurality of artificial neural network (ANN) layers. The ANN may include a deep neural network (DNN), a convolutional neural network (CNN), a recurrent neural network (RNN), a restricted boltzman machine (RBM), a deep belief network (DBN), a bidirectional recurrent deep neural network (BRDNN), a deep Q-networks or the combination of the above networks, but the disclosure is not limited thereto. The AI model may additionally or alternatively include a software structure, in addition to a hardware structure.

The memory 130 may be configured to store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may be configured to output sound signals to the outside of the electronic device 101. The sound output module 155 may include, for example, a speaker or a receiver. The speaker may be used for general purposes, such as playing multimedia or playing record, and the receiver may be used for an incoming calls. In an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to another embodiment, the display module 160 may include touch sensor adapted to detect a touch, or a pressure sensor adapted to measure the intensity of force incurred by the touch.

The audio module 170 may convert a sound into an electrical signal and vice versa. According to another embodiment, the audio module 170 may obtain the sound via the input module 150, or output the sound via the sound output module 155 or an external electronic device (e.g., the electronic device 102) (e.g., speaker of headphone) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to another embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. In an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). In another embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to another embodiment, the haptic module 179 may include, for example, a motor, a piezoelectric element, or an electric stimulator.

The camera module 180 may capture a still image or moving images. According to another embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. In an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may, for example, include one or more communication processors that are operable independently from the processor 120 (e.g., the application processor (AP)) and supports a direct (e.g., wired) communication or a wireless communication. According to one embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). The corresponding communication module from among the communication modules may communicate with the external electronic device via the first network 198 (e.g., a short-range communication network, such as Bluetooth^{™}, wireless-fidelity (WiFi) direct, or infrared data association (IrDA)) or the second network 199 (e.g., a long-range communication network, such as a legacy cellular network, 5G network, next generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may, for example, identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network and a next-generation communication technology, for example, a new radio (NR) access technology after a 4G network. In an embodiment, the NR access technology may support high-speed transmission for high capacity data (enhanced mobile broadband; eMBB), terminal power minimizing and multiple terminal access (massive machine type communication; mMTC), or ultra-reliable and low-latency communications (URLLC). The wireless communication module 192 may support a high-frequency band (e.g., mmWave band) to achieve, for example, a higher data rate. The wireless communication module 192 may support various technologies, for example, beamforming, massive multiple-input and multiple-output (MIMO), Full-dimensional MIMO, an array antenna, analog beam-forming, or a large-scale antenna, to secure performance in high frequency bands. The wireless communication module 192 may support various requirements defined in the electronic device 101, the external electronic device (e.g., the electronic device 104) or the network system (e.g., the second network 199). According to another embodiment, the wireless communication module 192 may support a peak data rate (e.g., 20Gbps or more) for eMBB realization, loss coverage (e.g., 164 dB or less) for mMTC realization, or U-plane latency (e.g., 0.5 ms or less, or the round trip of 1 ms or less in each of a downlink (DL) and an uplink (UL)) for URLCC realization.

The antenna module 197 may transmit or receive a signal or power to or from the outside (e.g., the external electronic device) of the electronic device 101. In an embodiment, the antenna module 197 may include an antenna including a radiating element composed of a conductive material or a conductive pattern formed in or on a substrate (e.g., PCB). According to another embodiment, the antenna module 197 may include a plurality of antennas (e.g., an array antenna). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to yet another embodiment, another component (e.g., a radio frequency integrated circuit (RFIC)) other than the radiating element may be additionally formed as part of the antenna module 197.

According to some embodiments, the antenna module 197 may form an mmWave antenna module. According to one embodiment, the mmWave antenna module may include a printed circuit board, an RFIC disposed on a first surface (e.g., a bottom surface) of the printed circuit board, or disposed adjacent to the first surface to support the specific high frequency band (e.g., mmWave band), and a plurality of antennas (e.g., an array antenna) disposed on a second surface (e.g., a top surface or a side surface) of the printed circuit board or disposed adjacent to the second surface to transmit or receive a signal having the specified high frequency band.

At least some of the above-described components may be coupled mutually and communicate signals (e.g., commands or data) therebetween via an interperipheral communication scheme (e.g., a bus, general purpose input and output (GPIO), serial peripheral interface (SPI), or mobile industry processor interface (MIPI)).

Commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or server 108. For example, when the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may, for example, provide the outcome, with or without further processing of the outcome, as at least part of a reply to the request. To that end, a cloud computing, distributed computing, mobile edge computing (MEC), or client-server computing technology may be used, for example. The electronic device 101 may provide an ultra-latency service by using, for example, distributed computing or mobile edge computing. According to various embodiments, the external electronic device 104 may include the Internet of things (IoT). The server 108 may be an artificial server using machine learning and/or a neural network. According to another embodiment, the external electronic device 104 or the server 108 may be included in the second network 199. The electronic device 101 may be applied to an artificial intelligence service (e.g., a smart home, a smart city, a smart car, or healthcare service) based on the 5G communication technology and the IoT-related technology.

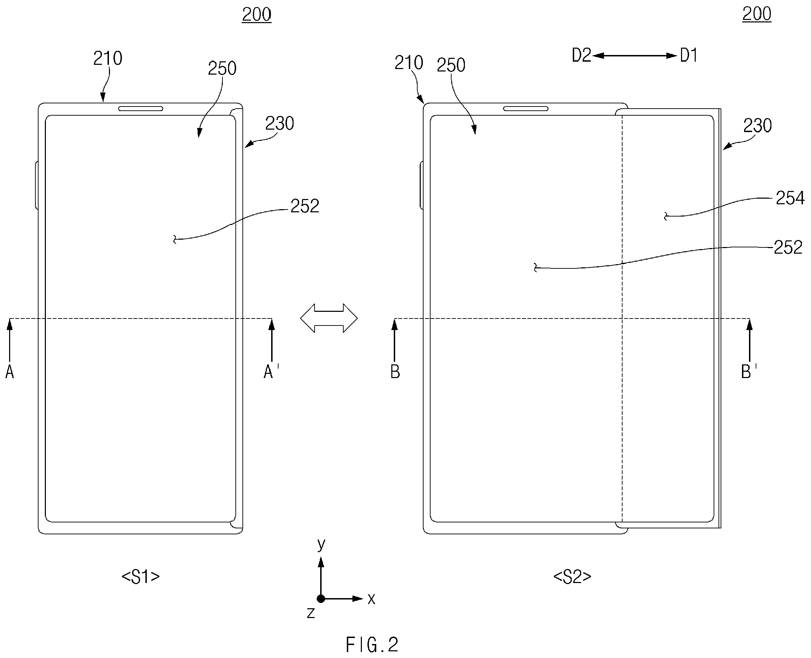

FIG. 2 is a view illustrating a first state and a second state of an electronic device according to an embodiment of the disclosure.

Referring to FIG. 2, an electronic device 200 according to an embodiment (e.g., an electronic device 101 of FIG. 1) may include a first housing 210, a second housing 230, and a display 250.

In an embodiment, the electronic device 200 may be a slidable or rollable electronic device, and the state of the electronic device 200 may be changed by movement of the second housing 230 relative to the first housing 210. The state of the electronic device 200 may include the first state S1 (e.g., a closed mode, a reduced mode, a slide-in mode, or a minimum size mode) and the second state S2 (e.g., an open mode, an extended mode, a slide-out mode, or a maximum size mode). The first state S1 and the second state S2 of the electronic device 200 may be determined depending on the position of the second housing 230 relative to the first housing 210. The electronic device 200 may be changed (or, switched) between the first state S1 and the second state S2 by a user operation or a mechanical operation (e.g., a motor).

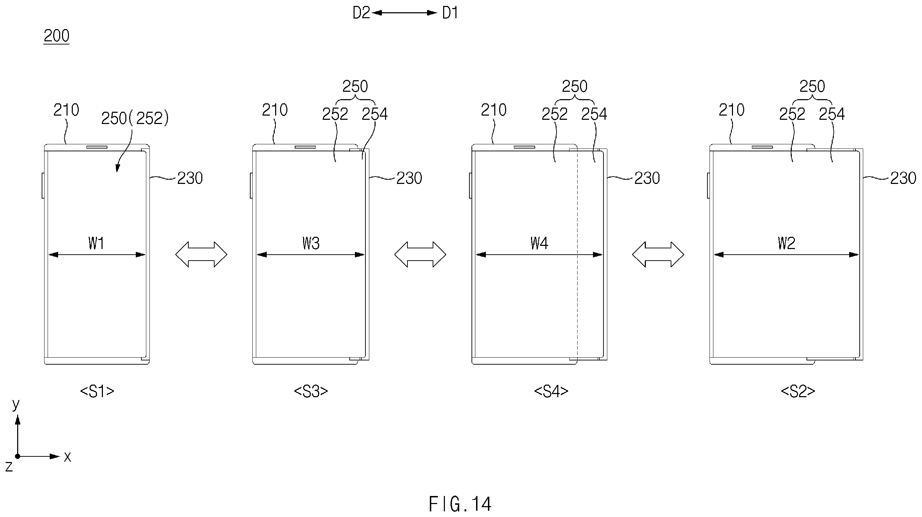

In another embodiment, the first state S1 may refer to a state in which the area (or, size) of an exposed region of the display 250 that is exposed on the front surface (e.g., a surface facing in the +z-axis direction) of the electronic device 200 (or, forms the front surface) is relatively reduced. The second state S2 may refer to a state in which the area (or, size) of the exposed region of the display 250 that is exposed on the front surface of the electronic device 200 (or, forms the front surface) is relatively extended. In an example, the first state S1 may refer to a state in which the exposed region of the display 250 visually exposed on the front surface of the electronic device 200 has a minimum size, and the second state S2 may refer to a state in which the exposed region of the display 250 exposed on the front surface of the electronic device 200 has a maximum size. Although not illustrated, the state of the electronic device 200 may further include at least one intermediate state (e.g., a partially extended state or a partially open state) that is defined as a state between the first state S1 and the second state S2. For example, the at least one intermediate state (e.g., a third state S3 or a fourth state S4 of FIG. 14) may refer to at least one state in which the size of the exposed region of the display 250 is larger than that in the first state S1 and smaller than that in the second state S2.

In yet another embodiment, the first state S1 may refer to a closed state in which a portion of the second housing 230 is located in the first housing 210 so that the second housing 230 is closed to the first housing 210. The second state S2 may refer to an opened state in which the portion of the second housing 230 located in the first housing 210 in the first state S1 moves out of the first housing 210 so that the second housing 230 is open to the first housing 210.

In still another embodiment, the first housing 210 and the second housing 230 may be coupled to slide relative to each other. The second housing 230 may be coupled to one side of the first housing 210 so as to slide. For example, the first housing 210 may be a relatively fixed structure, and the second housing 230 may be a structure movable relative to the first housing 210. The second housing 230 may be coupled to the one side of the first housing 210 so as to slide relative to the first housing 210 in opposite directions D1 and D2 (e.g., the +x/-x-axis directions).

The second housing 230 may be provided to change the state of the electronic device 200 by sliding relative to the first housing 210. For example, the electronic device 200 may be changed to the second state S2 as the second housing 230 moves relative to the first housing 210 in the first direction D1 in the first state S1 (e.g., the state of FIG. 1). In contrast, the electronic device 200 may be changed to the first state S1 as the second housing 230 moves relative to the first housing 210 in the second direction D2 opposite to the first direction D1 in the second state S2.

According to some embodiments, the first housing 210 may mean a fixed member, a fixed housing, a fixed case, or a main body. The second housing 230 may mean a sliding member (a slider), a sliding housing, a sliding case, or a sliding body.

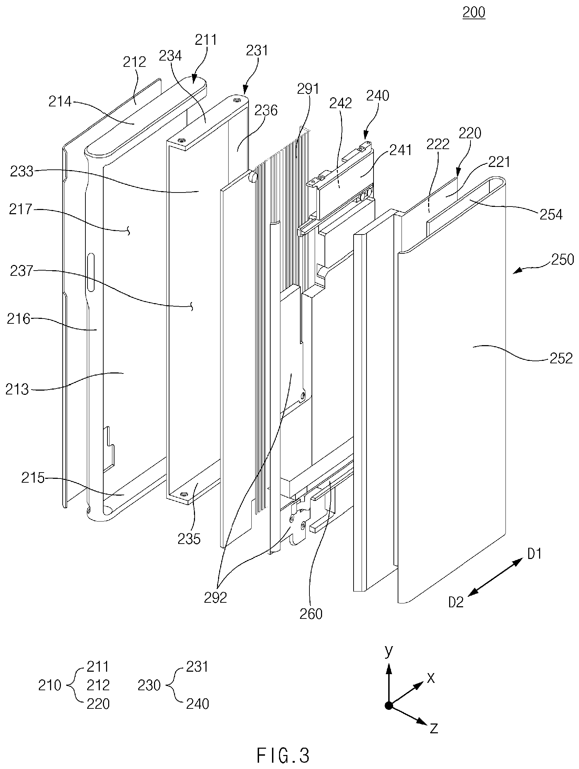

In other embodiments, the size of the exposed region of the display 250 visually exposed on the front surface of the electronic device 200 may be changed in response to a sliding operation of the second housing 230. The display 250 may be, for example, configured such that the region exposed on the front surface of the electronic device 200 is extended or reduced as at least a portion of the display 250 rotates and linearly moves depending on the sliding operation of the second housing 230 in a state in which the display 250 is supported by other components (e.g., a first support member 220 and a display support member 291 of FIG. 3) of the electronic device 200. The display 250 may at least partially include a flexible portion. For example, the display 250 may be a flexible display.

In an embodiment, the display 250 may include a first region 252 and a second region 254 extending from the first region 252. The first region 252 may form the front surface of the electronic device 200. In an example, the first region 252 may remain visually exposed on the front surface of the electronic device 200 irrespective of the state of the electronic device 200. The second region 254 may form the front surface of the electronic device 200 in a state in which the size of the electronic device 200 is extended when compared to that in the first state S1. In another example, whether the second region 254 is exposed on the front surface of the electronic device 200 may be determined depending on the state of the electronic device 200. Depending on movement of the second housing 230, the second region 254 may be inserted or accommodated (e.g., slid) into the second housing 230, or may be withdrawn or exposed (e.g., slid) out of the second housing 230.

The area by which the second region 254 is exposed on the front surface of the electronic device 200 may vary depending on the position of the second housing 230 relative to the first housing 210. For example, as the second housing 230 moves in the first direction D1 in the first state S1, the size of the second region 254 exposed on the front surface of the electronic device 200 may be gradually increased. The exposed area of the second region 254 may be increased with an increase in the distance by which the second housing 230 moves in the first direction D1 in the first state S1. In some embodiments, the first region 252 may be understood as a default region, a fixed region, or a main region, and the second region 254 may be understood as an extended region, a variable region, or a sub-region.

In another embodiment, the second region 254 may extend from the first region 252 in one direction. For example, the direction in which the second region 254 extends from the first region 252 may be substantially the same as the direction (e.g., the first direction D1) in which the second housing 230 moves when the electronic device 200 is extended. For example, the second region 254 may extend from the first region 252 in the first direction D1. As the second housing 230 slides relative to the first housing 210, the second region 254 may be inserted (e.g., slid) into the second housing 230, or may be withdrawn (e.g., slid) out of the second housing 230.

In yet another embodiment, the first region 252 and the second region 254 of the display 250 may be distinguished from each other depending on whether the first region 252 and the second region 254 are exposed on the front surface of the electronic device 200 in the first state S1. The first region 252 may refer to a partial region of the entire region of the display 250 that is visually exposed on the front surface of the electronic device 200 in the first state S1. The second region 254 may refer to another region of the entire region of the display 250 that is located in the second housing 230 so as not to be exposed on the front surface of the electronic device 200 in the first state S1 and that is at least partially moved out of the second housing 230 so as to be visually exposed on the front surface of the electronic device 200 when the electronic device 200 is changed from the first state S1 to the second state S2. For example, the second region 254 may be understood as indicating the remaining region other than the first region 252 in the entire region of the display 250. In some embodiments of the disclosure, the first region 252 and the second region 254 of the display 250 are not physically separated regions and do not mean that the shapes or properties are different from each other.

The first state S1 may be a state in which the front surface of the electronic device 200 is formed by the first region 252 and the second region 254 is located in the second housing 230. The second state S2 may be a state in which the front surface of the electronic device 200 is formed by at least a portion of the second region 254 and the first region 252. In an example, the second state S2 may refer to a state in which the area of the second region 254 exposed on the front surface of the electronic device 200 has a maximum size. Although not illustrated, the at least one intermediate state between the first state S1 and the second state S2 may refer to a state in which the area of the second region 254 exposed on the front surface of the electronic device 200 is smaller than that in the second state.

In some embodiments, the display 250 may form a screen display area that is visually exposed on the front surface of the electronic device 200 and on which certain visual information (or, a screen) is displayed. In the first state S1, the screen display area may be formed by the first region 252. In the second state S2, the screen display area may be formed by a portion of the second region 254 and the first region 252. In the second state S2, the electronic device 200 may provide a screen display area that is extended when compared to that in the first state S1. For example, the screen display area may be substantially the same as, or smaller than, the exposed region of the display 250.

The structure of the electronic device 200 that will be described below may correspond to an example of an electronic device in which the area of a screen display area is variable, and the electronic device having the variable screen display area may be implemented in various ways other than the structure disclosed herein. The term "state" used herein may be, for example, understood as referring to an operation of the electronic device or the structural form or shape of the display.

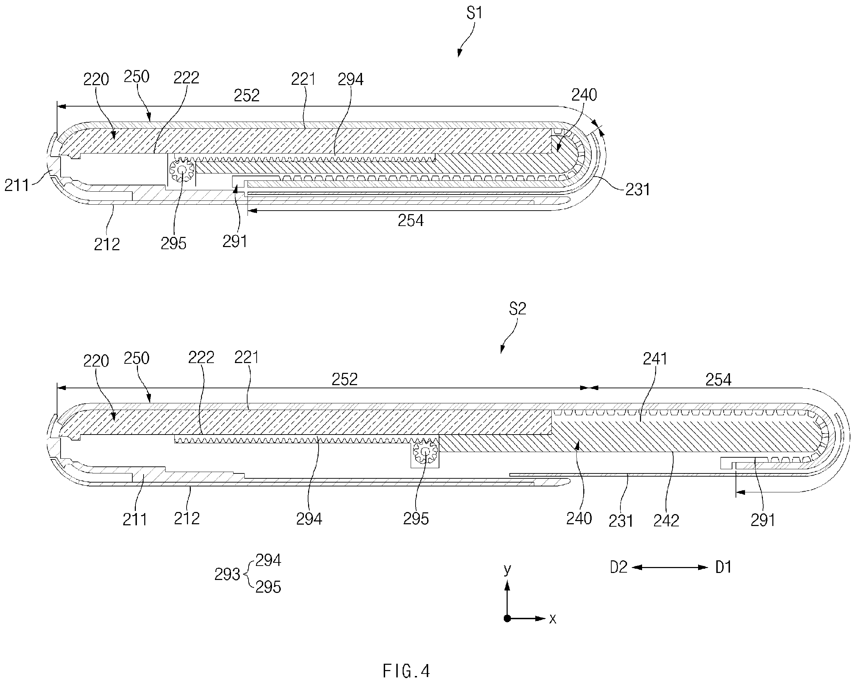

FIG. 3 is an exploded perspective view of an electronic device according to an embodiment of the disclosure. FIG. 4 is a sectional view of an electronic device according to an embodiment of the disclosure.

FIG. 4 illustrates a section of an electronic device 200 taken along line A-A' in a first state S1 illustrated in FIG. 2 and a section of the electronic device 200 taken along line B-B' in a second state S2 illustrated in FIG. 2 according to an embodiment of the disclosure.

Referring to FIGS. 3 and 4, the electronic device 200 according to an embodiment may include the first housing 210, the second housing 230, the display 250, the display support member 291, substrate members 292, and a drive member 293.

The first housing 210 may be a structure (or, members) fixed relative to a sliding operation of the second housing 230. For example, the first housing 210 may be a fixed part relative to which the second housing 230 slides.

In one embodiment, the first housing 210 may include a fixed cover (e.g., a rear case) 211, a back plate 212, and the first support member (e.g., a front case or bracket) 220. For example, the first housing 210 may be formed in a structure in which the back plate 212 and the first support member 220 are coupled to the fixed cover 211. The back plate 212 and the first support member 220 may be fixedly coupled to the fixed cover 211, and the second housing 230 may move relative to the fixed cover 211, the back plate 212, and the first support member 220. According to the illustrated embodiment, the fixed cover 211 and the back plate 212 may be formed as separate parts. In various embodiments, the fixed cover 211 and the back plate 212 may be integrally formed with each other.

In another embodiment, the fixed cover 211, together with the back plate 212, may form a portion of the exterior of the electronic device 200. For example, the fixed cover 211 may form the rear surface (e.g., a surface facing in the -z-axis direction) of the electronic device 200 and at least some of the side surfaces (e.g., a surface facing in the x-axis or y-axis direction) of the electronic device 200. The fixed cover 211 may support the back plate 212 and the first support member 220. For another example, the back plate 212 may be coupled to the fixed cover 211 in the rear direction (e.g., the -z-axis direction), and the first support member 220 may be coupled to the fixed cover 211 in the front direction (e.g., the +z-axis direction).

In yet another embodiment, a sliding cover 231 may be accommodated in a first inner space 217 of the fixed cover 211 so as to slide in the opposite directions D1 and D2. The fixed cover 211 may include a first plurality of sidewalls 214, 215, and 216 and a first plate portion 213 that form the first inner space 217. For example, the first plurality of sidewalls 214, 215, and 216 may extend substantially perpendicularly from edges of the first plate portion 213.

In still another embodiment, the first plate portion 213 may be formed to be substantially flat. The first plate portion 213 may face the first support member 220 with the second housing 230 therebetween. For example, the sliding cover 231 and a second support member 240 may be disposed between the first plate portion 213 and the first support member 220 so as to slide.

The first plurality of sidewalls 214, 215, and 216 may include the first sidewall 214 extending substantially perpendicularly from the first plate portion 213, the second sidewall 215 extending to face the first sidewall 214, and the third sidewall 216 connecting the first sidewall 214 and the second sidewall 215. In an example, the third sidewall 216 may extend substantially perpendicular to the first sidewall 214 and the second sidewall 215 so as to connect one end portion of the first sidewall 214 and one end portion of the second sidewall 215. According to the illustrated embodiment, the third sidewall 216 may extend from the first plate portion 213 while forming a curved surface. However, this is illustrative, and the shape of the third sidewall 216 is not limited to the illustrated embodiment.

In one embodiment, the first sidewall 214 may form the side surface facing in the +y-axis direction among the side surfaces of the electronic device 200, the second sidewall 215 may form the side surface facing in the -y-axis direction among the side surfaces of the electronic device 200, and the third sidewall 216 may form the side surface facing in the -x-axis direction among the side surfaces of the electronic device 200. The portion of the fixed cover 211 that faces the third sidewall 216 may be open such that the sliding cover 231 is movable through the portion.

In another embodiment, the back plate 212 may be coupled to the fixed cover 211 to form the rear surface (e.g., the surface facing in the -z-axis direction) of the electronic device 200. The back plate 212 may be coupled to the outer surface of the first plate portion 213. According to various embodiments, the back plate 212 may be integrally formed with the fixed cover 211, or may be omitted.

In an embodiment, the first support member 220 may be coupled to the fixed cover 211. As an example, at least a portion of the first support member 220 may be coupled to a portion of the fixed cover 211 such that the first support member 220 integrally moves with the fixed cover 211. As the first support member 220 is coupled to the fixed cover 211, a space in which a portion of the sliding cover 231 (e.g., a second plate portion 233) and the second support member 240 are disposed so as to be movable may be formed between the first support member 220 and the fixed cover 211. The first support member 220 may be disposed such that at least a portion thereof faces the second support member 240.

In still another embodiment, the first support member 220 may support the display 250 and the substrate members 292. The first support member 220 may be formed in a substantially plate shape and may have a specified rigidity. For example, the first support member 220 may be formed of a metallic material and/or a nonmetallic material (e.g., a polymer). The first support member 220 may include a first surface 221 facing in the front direction of the electronic device 200 (e.g., the +z-axis direction) and a second surface 222 facing away from the first surface 221 (e.g., facing in the -z-axis direction). In another example, the first surface 221 may face at least a portion of the display 250, and the second surface 222 may face the second support member 240.

In an embodiment, the first surface 221 of the first support member 220 may support at least a portion of the display 250. For example, the first surface 221 of the first support member 220 may be formed flat to support the display 250. The first region 252 of the display 250 may be disposed on the first surface 221 of the first support member 220. In yet another example, at least a portion of the first region 252 may be fixed to the first surface 221 of the first support member 220 to integrally move with the first support member 220. The first surface 221 of the first support member 220 may be attached to at least a portion of the first region 252 through an adhesive member (e.g., a double-sided tape). However, without being limited thereto, a fixing method may be changed in various ways.

The second surface 222 of the first support member 220 may support the substrate members 292. For example, the substrate members 292 may be fixed to the second surface 222 of the first support member 220 to integrally move with the first support member 220. The second surface 222 of the first support member 220 may partially face one surface of the second support member 240. For example, the first support member 220 may partially overlap the second support member 240 when the first support member 220 is viewed in the front direction (e.g., the +z-axis direction). When the second housing 230 slides relative to the first housing 210, the area of the region of the second surface 222 that faces the second support member 240 may vary as the second support member 240 moves in a state in which the first support member 220 is relatively fixed. The second surface 222 facing the second support member 240 may have a maximum size in the first state S1. The second surface 222 may be gradually reduced in a process in which the electronic device 200 is changed from the first state S1 to the second state S2 and may have a minimum size in the second state.

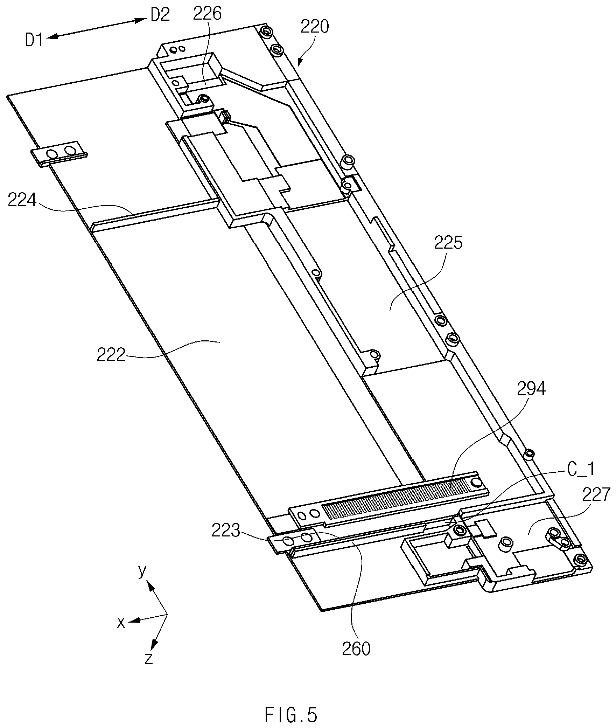

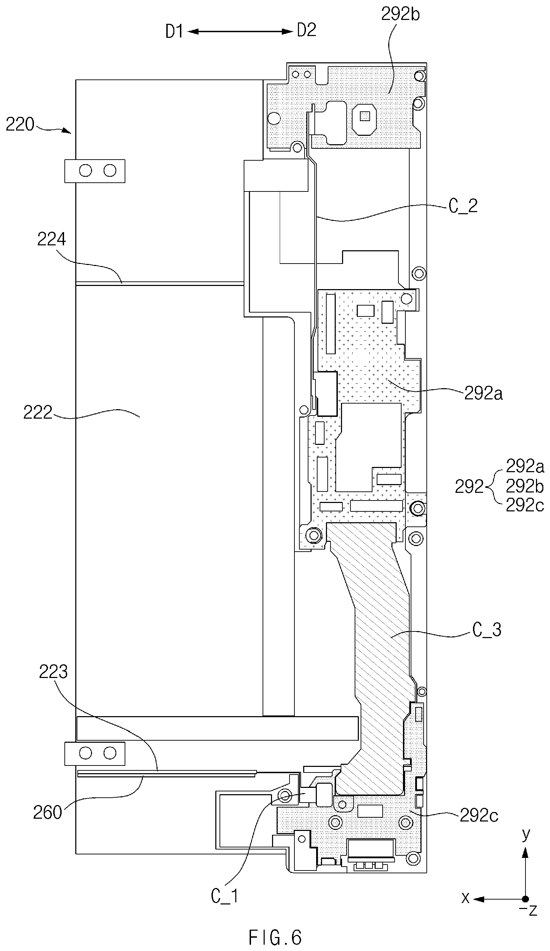

In one embodiment, a rack gear 294 and a sensing substrate 260 may be disposed on the second surface 222 of the first support member 220. The first support member 220 may integrally move with the rack gear 294 and the sensing substrate 260. The rack gear 294 and the sensing substrate 260, together with the first support member 220, may remain in a relatively fixed state with respect to sliding of the second support member 240. An arrangement structure of the rack gear 294 and the sensing substrate 260 will be described below with reference to FIGS. 5 and 6.

In another embodiment, the second housing 230 may be configured to slide in the first direction D1 and the second direction D2 relative to the first housing 210. For example, the second housing 230 may be a moving part that moves relative to the first housing 210 (e.g., the fixed part). The second housing 230 may move relative to the fixed cover 211 and the first support member 220 in the first direction D1 and the second direction D2 in a state in which at least a portion of the second housing 230 is disposed in the space between the fixed cover 211 and the first support member 220. For example, a portion of the second housing 230 may be surrounded by the first plate portion 213, the first plurality of sidewalls 214, 215, and 216, and the first support member 220.

In yet another embodiment, the second housing 230 may include the sliding cover 231 and the second support member 240. For example, the second housing 230 may be formed in a structure in which the sliding cover 231 and the second support member 240 are coupled to each other. The sliding cover 231 and the second support member 240 may be coupled to each other to integrally move and may move relative to the first housing 210.

In still another embodiment, the sliding cover 231 may be accommodated in the first inner space 217 of the fixed cover 211 so as to slide. The second support member 240 may be coupled to a second inner space 237 of the sliding cover 231. The sliding cover 231 may include a second plurality of sidewalls 234, 235, and 236 and the second plate portion 233 that form the second inner space 237. The second plurality of sidewalls 234, 235, and 236 may extend substantially perpendicularly from edges of the second plate portion 233.

The second plate portion 233 may face the first plate portion 213 of the fixed cover 211. The second plate portion 233 may be formed substantially flat and may be substantially parallel to the first plate portion 213. The second plate portion 233 may be disposed between the first plate portion 213 and the first support member 220. For example, the sliding cover 231 may be configured to move relative to the fixed cover 211 in a state in which the second plate portion 233 partially overlaps the first plate portion 213.

In an embodiment, the second plurality of sidewalls 234, 235, and 236 may include the fourth sidewall 234 extending substantially perpendicularly from the second plate portion 233, the fifth sidewall 235 extending to face the fourth sidewall 234, and the sixth sidewall 236 connecting the fourth sidewall 234 and the fifth sidewall 235. In an example, the sixth sidewall 236 may extend substantially perpendicular to the fourth sidewall 234 and the fifth sidewall 235 so as to connect one end portion of the fourth sidewall 234 and one end portion of the fifth sidewall 235. According to the illustrated embodiment, the sixth sidewall 236 may extend from the second plate portion 233 while forming a curved surface. However, this is illustrative, and the shape of the sixth sidewall 236 is not limited to the illustrated embodiment.

In another embodiment, the fourth sidewall 234 may extend parallel to the first sidewall 214 of the fixed cover 211, and the fifth sidewall 235 may extend parallel to the second sidewall 215 of the fixed cover 211. The sliding cover 231 may be disposed inside the fixed cover 211 such that the fourth sidewall 234 faces the inner surface of the first sidewall 214 and the fifth sidewall 235 faces the inner surface of the second sidewall 215. As an example, the sliding cover 231 may be configured to move relative to the fixed cover 211 in a state in which the fourth sidewall 234 partially overlaps the first sidewall 214 and the fifth sidewall 235 partially overlaps the second sidewall 215.

In still another embodiment, when the electronic device 200 is in the second state S2, the fourth sidewall 234 and the fifth sidewall 235 may form some of the side surfaces of the electronic device 200 together with the first sidewall 214 and the second sidewall 215. For example, in the second state S2, the fourth sidewall 234, together with the first sidewall 214, may form the side surface facing in the +y-axis direction among the side surfaces of the electronic device 200. In the second state, the fifth sidewall 235, together with the second sidewall 215, may form the side surface facing in the -y-axis direction among the side surfaces of the electronic device 200. When the electronic device 200 is in the first state S1, the fourth sidewall 234 and the fifth sidewall 235 may be hidden by the first sidewall 214 and the second sidewall 215 and may not be exposed in the lateral directions (e.g., the y-axis directions) of the electronic device 200, and when the electronic device 200 is changed from the first state S1 to the second state S2, the fourth sidewall 234 and the fifth sidewall 235 may be exposed. The sixth sidewall 236 may face the third sidewall 216 and may form the side surface facing in the +x-axis direction among the side surfaces of the electronic device 200. The sliding cover 231 may be formed in a shape in which the portion facing the sixth sidewall 236 is open.

The second support member 240 may be coupled to the sliding cover 231. At least a portion of the second support member 240 may be coupled to a portion of the sliding cover 231 such that the second support member 240 integrally moves with the sliding cover 231. The second support member 240 may be coupled to the inner surface of the fourth sidewall 234 and the inner surface of the fifth sidewall 235 of the sliding cover 231. Since the second support member 240 is coupled to the sliding cover 231, the second support member 240, together with the sliding cover 231, may move relative to the first housing 210 in the first direction D1 and the second direction D2. The second support member 240 may be disposed such that at least a portion thereof faces the second surface 222 of the first support member 220.

In one embodiment, the second support member 240 may include a third surface 241 facing in the front direction of the electronic device 200 (e.g., the +z-axis direction) and a fourth surface 242 facing away from the third surface 241 (e.g., facing in the -z-axis direction). For example, the third surface 241 may face a portion of the second surface 222 of the first support member 220, and the fourth surface 242 may face the second plate portion 233. The second support member 240 may be partially surrounded by the display support member 291. In another example, the second support member 240 may be surrounded from at least a portion of the third surface 241 to at least a portion of the fourth surface 242 across a side surface (e.g., a surface facing in the first direction D1) by the display support member 291.

In an embodiment, the display 250 may be supported by the first support member 220 and the display support member 291. One partial region of the display 250 may be supported by the first support member 220 and may be fixed to the first housing 210, and another partial region of the display 250 may be supported by the display support member 291 and may be configured to partially perform a rotational motion and a linear motion to correspond to a sliding operation of the second housing 230.

In another embodiment, the display 250 may include the first region 252 and the second region 254 extending from the first region 252. A portion of the first region 252 may be disposed on the first surface 221 of the first support member 220. For example, a portion of the first region 252 may be fixedly attached to the first surface 221 of the first support member 220. The second region 254 may be supported by the display support member 291. For example, the display support member 291 may be attached to the rear surface of the second region 254, and the second region 254 may move together with the display support member 291.

In yet another embodiment, the first region 252 of the display 250 may be a region that forms the front surface of the electronic device 200 in the first state S1. The second region 254 of the display 250 may be a region, at least a portion of which forms the front surface of the electronic device 200 together with the first region 252 when the electronic device 200 is changed from the first state S1 to the second state S2.In the first state S1, the second region 254 may be disposed in the second housing 230, and in a process in which the electronic device 200 is changed to the second state S2, at least a portion of the second region 254 may move out of the second housing 230 and may form the front surface of the electronic device 200. A portion of the second region 254 may move (e.g., slide-out or slide-in) in the space between the second support member 240 and the sliding cover 231.

One portion of the first region 252 may be supported by the first surface 221 of the first support member 220, and another portion of the first region 252 may be supported by the display support member 291. The second region 254 may be supported by the display support member 291. The smoothness of a partial region of the display 250 (e.g., the other portion of the first region 252 and the second region 254) supported by the display support member 291 may be maintained as the display support member 291 is disposed while partially surrounding the second support member 240.

The portion of the display 250 supported by the first support member 220 may be a portion that remains substantially flat irrespective of movement of the second housing 230. The portion of the display 250 supported by the display support member 291 may be a portion that is deformed to be curved or flat depending on the movement of the second housing 230. For example, the portion of the display 250 supported by the first support member 220 may be a rigid portion, and the portion of the display 250 supported by the display support member 291 may be a flexible portion. According to the illustrated embodiment, the first region 252 may include a rigid portion and a flexible portion, and the second region 254 may include only a flexible portion. Without being limited thereto, the entire display 250 may be formed of a flexible material.

In an embodiment, the first region 252 and the second region 254 of the display 250 may be understood as regions distinguished from each other depending on whether the regions are exposed in the front direction of the electronic device 200 when the electronic device 200 is in the first state. As an example, based on the sectional view of FIG. 4, a partial region of the display 250 partially exposed when the electronic device 200 in the first state S1 is viewed in the front direction (e.g., the +z-axis direction) may be defined as the first region 252. The position of the boundary between the first region 252 and the second region 254 is not limited to a specific position according to the illustrated embodiment. For example, when a portion of the second housing 230 (e.g., the sixth sidewall 236 of the sliding cover 231) surrounding the display 250 is formed in a higher or lower position than that in the illustrated embodiment, the positions of the first region 252 and the second region 254 may be changed accordingly.

In another embodiment, the display support member 291 may support at least a partial region of the display 250. The display support member 291 may be attached to the rear surface of the display 250, and at least a portion of the display support member 291 may be bent (or, curved) in response to sliding of the second housing 230. The display support member 291 may be implemented in a bendable form to partially form a curved surface in response to the sliding of the second housing 230. The display support member 291 may be formed of a metallic material or a polymer material, but is not limited thereto.

In an embodiment, the display support member 291 may support a portion of the first region 252 and the second region 254. For example, the display support member 291 may be attached, through an adhesive member, to portions of the rear surface of the display 250 that correspond to the portion of the first region 252 and the second region 254. The display support member 291 may move together with a partial region of the display 250. The display support member 291 may be configured to support a portion of the entire region of the display 250 that is deformed to be curved or flat depending on a state of the electronic device 200.

In another embodiment, the display support member 291 may include a plurality of bars extending in a direction substantially perpendicular to the sliding directions D1 and D2 of the second housing 230. For example, the display support member 291 may be formed in a form in which a plurality of bars extending in the lengthwise direction of the display 250 (e.g., the y-axis direction) are spaced apart from each other at certain intervals (e.g., in the form a multi-joint module or a multi-bar module). In various embodiments, the display support member 291 may refer to a flexible track or a hinge rail. The display support member 291 may be bent at portions having a relatively small thickness between the plurality of bars. Without being limited to the multi-bar module, the display support member 291 may include various structures (e.g., a lattice structure) that are bendable while supporting the display 250.

In yet another embodiment, the display support member 291 may surround at least a portion of the second support member 240. For example, the display support member 291 may be disposed inside the sliding cover 231 in a form that partially surrounds the second support member 240. The display support member 291 may be partially bent while surrounding the second support member 240, and a partial region of the display 250 supported by the display support member 291 may be bent to correspond to the display support member 291.

A portion of the display support member 291 may be disposed between the sliding cover 231 and the second support member 240 and may move along the side surface of the second support member 240 in response to sliding of the second housing 230, and the partial region of the display 250 supported by the display support member 291 may also move together with the display support member 291. In an example, the display support member 291 may move along the side surface in a state of being brought into contact with at least a portion of the side surface of the second support member 240. The side surface of the second support member 240 may be formed to be a substantially curved surface such that the display support member 291 is able to perform a sliding motion. The illustrated embodiment is illustrative, and without being limited thereto, according to various embodiments, a roll bar for guiding rotational movement of the display support member 291 may be disposed on the side surface of the second support member 240. The roll bar may be coupled to the second support member 240 so as to be rotatable, or the surface of the roller bar brought into contact with the display support member 291 may be formed to be a curved surface.

In another embodiment, the substrate members 292 may be disposed in the first housing 210. For example, the substrate members 292 may be supported by the first support member 220 and may be fixed to the first housing 210 accordingly. The substrate members 292, together with the first housing 210, may remain fixed relative to the second housing 230 when the second housing 230 slides. The substrate members 292 may include a plurality of sub-substrates.

In yet another embodiment, the substrate members 292 may include a printed circuit board (PCB), a flexible PCB (FPCB), or a rigid-flexible PCB (RFPCB). Various electronic parts included in the electronic device 200 may be electrically connected to the substrate members 292. A processor (e.g., the processor 120 of FIG. 1), a memory (e.g., the memory 130 of FIG. 1), and/or an interface (e.g., the interface 177 of FIG. 1) may be disposed on the substrate members 292.

In still another embodiment, the drive member 293 may be configured to move the second housing 230 relative to the first housing 210. For example, the drive member 293 may provide a driving force for moving the second housing 230. In various embodiments, the drive member 293 may be configured to receive power from a battery (e.g., the battery 189 of FIG. 1) included in the electronic device 200 and generate the driving force.

The drive member 293 may include the rack gear 294 and a pinion gear 295. The rack gear 294 may extend in a direction parallel to the sliding directions D1 and D2 of the second housing 230. The pinion gear 295 may be formed in a shape corresponding to the rack gear 294 so as to rotate in a state of being engaged with the rack gear 294. As an example, the pinion gear 295 may move relative to the rack gear 294 in the first direction D1 and the second direction D2 while rotating on the rack gear 294.

In one embodiment, the rack gear 294 may be coupled to the first housing 210, and the pinion gear 295 may be coupled to the second housing 230. For example, the rack gear 294 may be coupled to the first support member 220 so as to integrally move with the first housing 210. The pinion gear 295 may be coupled to the second support member 240 so as to integrally move with the second housing 230. The pinion gear 295 may be disposed on the second support member 240 so as to be rotatable in the clockwise and counterclockwise directions.

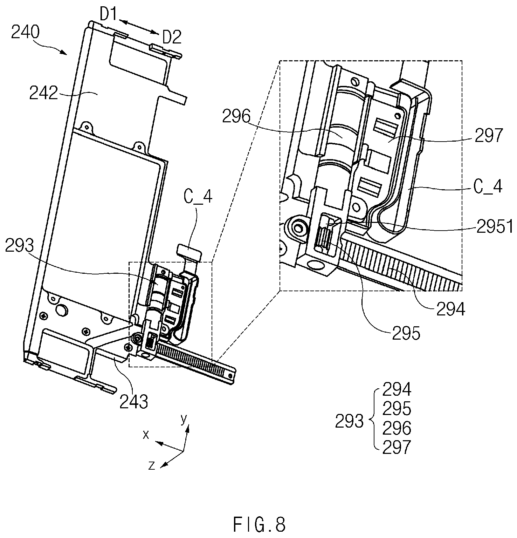

In another embodiment, the drive member 293 may move the second support member 240 (or, the second housing 230) in the first direction D1 and the second direction D2 as the pinion gear 295 engaged with the rack gear 294 linearly moves in the first direction D1 and the second direction D2 while rotating relative to the rack gear 294 in a state in which the rack gear 294 is relatively fixed together with the first support member 220. For example, based on FIG. 4, the drive member 293 may move the second housing 230 in the first direction D1 when the pinion gear 295 rotates in the counterclockwise direction and may move the second housing 230 in the second direction D2 when the pinion gear 295 rotates in the clockwise direction. Though not illustrated, the drive member 293 may further include a motor (e.g., a motor 296 of FIG. 8) for rotating the pinion gear 295.

According to the illustrated embodiment, the rack gear 294 may be disposed in the first housing 210, and the pinion gear 295 may be disposed in the second housing 230. The positions of the rack gear 294 and the pinion gear 295 may be interchanged. For example, the drive member 293 may be configured such that the rack gear 294 is disposed in the second housing 230 and the pinion gear 295 is disposed in the first housing 210. In this case, the pinion gear 295 may rotate at a specified position, and the rack gear 294 may be moved in the first direction D1 and the second direction D2 by the rotation of the pinion gear 295 to move the second housing 230.

The electronic device 200 illustrated in FIGS. 3 and 4 may be an embodiment of a slidable electronic device, and the structure of the electronic device 200 according to embodiments of the disclosure is not limited to the illustrated embodiment. In an example, the electronic device 200 may be implemented with various forms of slidable electronic devices that include a fixed housing and a movable housing movable relative to the fixed housing and in which a display region is extended or reduced as a flexible display moves together with the moving housing.

FIG. 5 is a view illustrating a first support member of an electronic device according to an embodiment of the disclosure. FIG. 6 is a view illustrating a first support member of an electronic device according to an embodiment of the disclosure.

FIGS. 5 and 6 may be a perspective view and a plan view when the second surface 222 of the first support member 220 is viewed from above.

Referring to FIGS. 5 and 6, an electronic device according to an embodiment (e.g., an electronic device 200 of FIGS. 2 to 4) may include a first support member 220, a sensing substrate 260, a substrate members 292, and a rack gear 294. The components illustrated in FIGS. 5 and 6 may be identical or similar to components of the electronic device 200 described with reference to FIGS. 2 to 4. Hereinafter, repetitive descriptions will be omitted.

In one embodiment, the first support member 220 may support the sensing substrate 260, the substrate members 292, and the rack gear 294. The first support member 220 may be configured such that the sensing substrate 260, the substrate members 292, and the rack gear 294 are disposed on the second surface 222. For example, the sensing substrate 260, the substrate members 292, and the rack gear 294 may be fixed to the second surface 222 of the first support member 220. The second surface 222 of the first support member 220 may be a surface facing toward the second support member (e.g., the second support member 240 of FIGS. 3 and 4). in another example, at least a portion of the second surface 222 of the first support member 220 may face the second support member 240. Based on the drawings, the second surface 222 of the first support member 220 may face in the -z-axis direction, and the display (e.g., the display 250 of FIGS. 3 and 4) may be disposed on the first surface 221 facing away from the second surface 222 (e.g., facing in the +z-axis direction).

In yet another embodiment, the first support member 220 may be fixed relative to movement of the second support member 240. When the second support member 240 moves, the sensing substrate 260, the substrate members 292, and the rack gear 294 may remain fixed to the first support member 220, and the positions of the sensing substrate 260, the substrate members 292, and the rack gear 294 relative to the second support member 240 may vary accordingly.

In still another embodiment, the first support member 220 may include a plurality of substrate regions 225, 226, and 227 on which the substrate members 292 are disposed. The plurality of substrate regions 225, 226, and 227 may be formed on partial regions of the second surface 222 of the first support member 220. The plurality of substrate regions 225, 226, and 227 may include the first substrate region 225 on which a first sub-substrate 292a is disposed, the second substrate region 226 on which a second sub-substrate 292b is disposed, and the third substrate region 227 on which a third sub-substrate 292c is disposed. The substrate members 292 may be coupled to the plurality of substrate regions 225, 226, and 227 in various ways. The substrate members 292 may be fixed to the plurality of substrate regions 225, 226, and 227 through screw-coupling, or may be attached to the plurality of substrate regions 225, 226, and 227 through an adhesive member.

In an embodiment, the first support member 220 may include a fixed portion 223 on which the sensing substrate 260 is disposed. The fixed portion 223 may be formed on a partial region of the second surface 222 of the first support member 220. As an example, the fixed portion 223 may extend substantially perpendicularly from the partial region of the second surface 222. The fixed portion 223 may protrude perpendicularly from the second surface 222 and may extend in a direction parallel to the sliding directions D1 and D2 of the second housing (e.g., the second housing 230 of FIGS. 2 to 4). The sensing substrate 260 may be fixed to the fixed portion 223. For example, the sensing substrate 260 may be attached to the fixed portion 223 through an adhesive member.

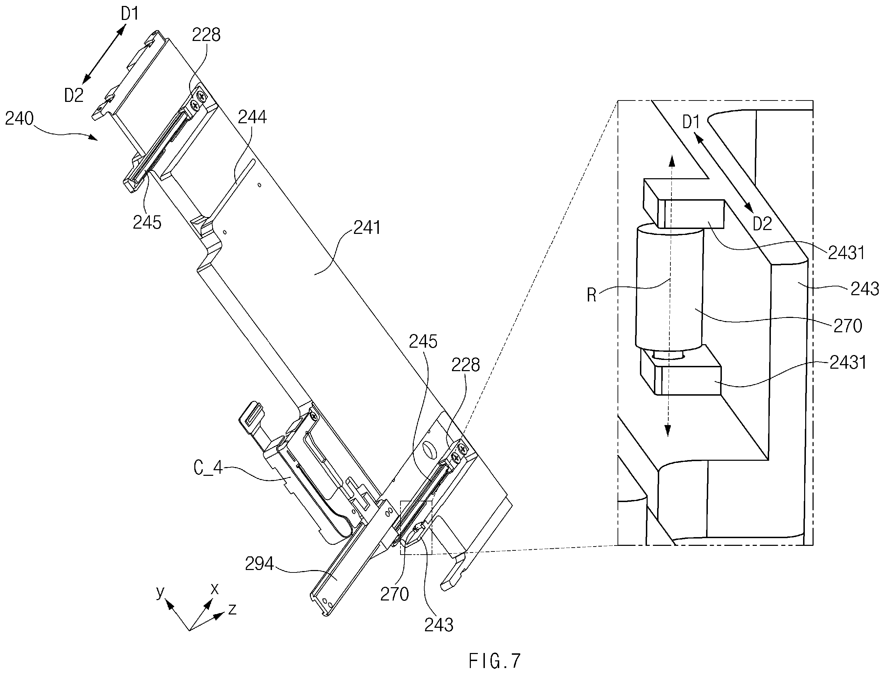

The second support member 240 may include a guide protrusion 224 for guiding movement of the second support member 240. The guide protrusion 224 may be formed on a partial region of the second surface 222 of the first support member 220. The guide protrusion 224 may protrude substantially perpendicularly from the partial region of the second surface 222 and may extend in the sliding directions D1 and D2. Though not illustrated, the guide protrusion 224 may be inserted into a guide groove (e.g., a guide groove 244 of FIG. 7) that is formed on the second support member 240 and may guide sliding of the second support member 240. For example, the guide protrusion 224 may move in the guide groove 244 in the sliding directions D1 and D2 depending on a change in the relative positions of the first support member 220 and the second support member 240.

In an embodiment, the sensing substrate 260 may be disposed on the fixed portion 223 of the first support member 220. The sensing substrate 260 may integrally move with the first support member 220. Since the sensing substrate 260 is fixed to the first support member 220, the position of the sensing substrate 260 relative to the second support member 240 may vary when the second support member 240 moves relative to the first support member 220 in the sliding directions D1 and D2.

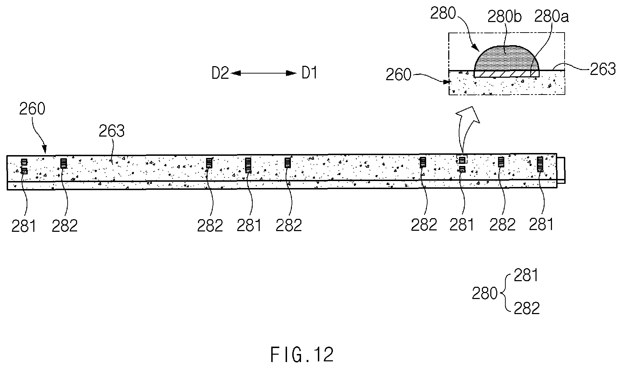

In another embodiment, the sensing substrate 260 may be electrically connected to the substrate members 292. For example, the sensing substrate 260 may be electrically connected to the third sub-substrate 292c through a first connector C_1. The sensing substrate 260 may include a printed circuit board (PCB), a flexible PCB (FPCB), or a rigid-flexible PCB (RFPCB). Sensing pads (not illustrated) for sensing the position of the second support member 240 may be disposed on the sensing substrate 260. The sensing pads 280 will be described below with reference to FIG. 12.

In still another embodiment, the substrate members 292 may be disposed on the plurality of substrate regions 225, 226, and 227 of the first support member 220. The substrate members 292 may integrally move with the first support member 220. The substrate members 292 may include the first sub-substrate 292a, the second sub-substrate 292b, and the third sub-substrate 292c. The first sub-substrate 292a may be disposed on the first substrate region 225, the second sub-substrate 292b may be disposed on the second substrate region 226, and the third sub-substrate 292c may be disposed on the third substrate region 227. The first sub-substrate 292a, the second sub-substrate 292b, and the third sub-substrate 292c may be electrically connected. For another example, the first sub-substrate 292a may be electrically connected with the second sub-substrate 292b through a second connector C_2 and may be electrically connected with the third sub-substrate 292c through a third connector C_3. The number and/or positions of substrate members 292 are not limited to the illustrated embodiment and may be changed according to various embodiments.

In an embodiment, the rack gear 294 may be disposed on a partial region of the second surface 222 of the first support member 220. For example, the rack gear 294 may be fixed to the second surface 222 through screw-coupling. A coupling method is not limited thereto. The rack gear 294 may integrally move with the first support member 220. The rack gear 294 may extend by a specified length in a direction parallel to the sliding directions D1 and D2.

FIG. 7 is a view illustrating a second support member of an electronic device according to an embodiment of the disclosure. FIG. 8 is a view illustrating a second support member of an electronic device according to an embodiment of the disclosure.

FIG. 7 may be a perspective view when a third surface 241 of a second support member 240 is viewed from above, and FIG. 8 may be a perspective view when a fourth surface 242 of a second support member 240 is viewed from above.

Referring to FIGS. 7 and 8, the electronic device according to an embodiment (e.g., the electronic device 200 of FIGS. 2 to 4) may include the second support member 240, a conductive member 270, and the drive member 293. The components illustrated in FIGS. 7 and 8 may be identical or similar to the components of the electronic device 200 described with reference to FIGS. 2 to 6. Hereinafter, repetitive descriptions will be omitted.

The second support member 240 may support the conductive member 270, the motor 296, and the pinion gear 295. The second support member 240 may be configured such that the conductive member 270 is disposed on the third surface 241 and the motor 296 and the pinion gear 295 are disposed on the fourth surface 242. For example, the third surface 241 of the second support member 240 may partially face the second surface (e.g., the second surface 222 of FIGS. 3 to 6) of the first support member (e.g., the first support member 220 of FIGS. 3 to 6). Based on the drawings, the third surface 241 of the second support member 240 may face in the +z-axis direction, and the fourth surface 242 of the second support member 240 may face in the -z-axis direction.

In another embodiment, the second support member 240 may move relative to the first support member 220 in the first direction D1 and the second direction D2. The conductive member 270, the motor 296, and the pinion gear 295 may move together with the second support member 240, and the positions of the conductive member 270, the motor 296, and the pinion gear 295 relative to the first support member 220 may vary accordingly.

In yet another embodiment, the second support member 240 may include a coupling portion 243 on which the conductive member 270 is disposed. The coupling portion 243 may be formed on a partial region of the third surface 241 of the second support member 240. The coupling portion 243 may be substantially perpendicular to the third surface 241. For another example, the coupling portion 243 may be formed in a corresponding position to face the fixed portion (e.g., the fixed portion 223 of FIGS. 5 and 6) of the first support member 220. The coupling portion 243 may face the fixed portion 223 while substantially paralleling the fixed portion 223. Coupling protrusions 2431 to which the conductive member 270 is coupled may be formed on the coupling portion 243.

In still another embodiment, the second support member 240 may include the guide groove 244 for guiding sliding of the second support member 240. The guide groove 244 may be formed on a partial region of the third surface 241. The guide groove 244 may extend in the sliding directions D1 and D2 by a certain length. The guide protrusion 224 formed on the second surface 222 of the first support member 220 may be inserted into the guide groove 244. The guide groove 244 may be formed in a corresponding position such that the guide protrusion 224 is inserted into the guide groove 244.

In yet another embodiment, the second support member 240 may include guide rails 245 for guiding sliding of the second support member 240. The guide rails 245 may be disposed on the third surface 241. For example, a pair of guide rails 245 may be formed. The pair of guide rails 245 may be disposed adjacent to opposite end portions of the third surface 241 in the y-axis direction. The guide rails 245 may extend in the sliding directions D1 and D2. Sliding support members 228 fixed to the first support member 220 may be fastened to the guide rails 245 so as to be movable. For example, as the sliding support members 228 move along the guide rails 245, the guide rails 245 may guide a sliding operation of the second support member 240 relative to the first support member 220. Though the first support member 220 is omitted in FIG. 7, the sliding support members 228 may be understood as being coupled to the first support member 220 to integrally move with the first support member 220.

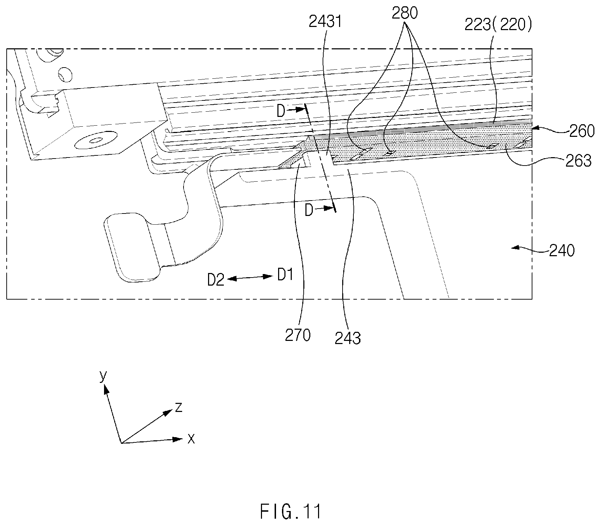

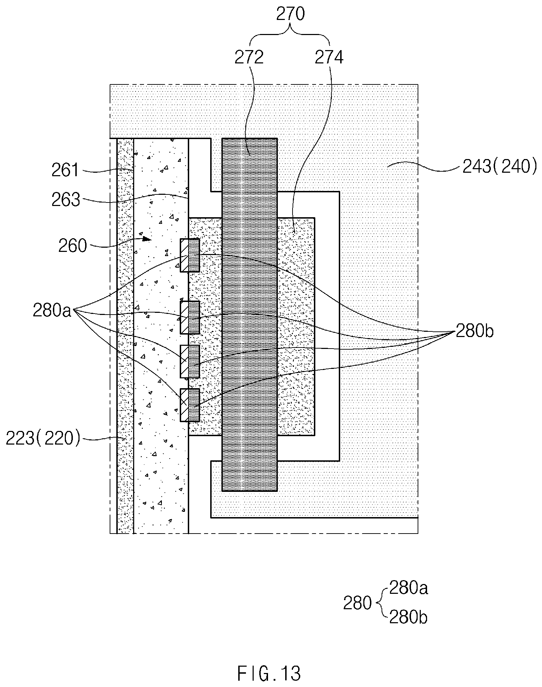

The conductive member 270 may be disposed on the coupling portion 243 of the second support member 240. For example, as the conductive member 270 is disposed on the coupling portion 243, the conductive member 270 may be disposed to face the sensing substrate (e.g., the sensing substrate 260 of FIGS. 5 and 6) disposed on the fixed portion 223 of the first support member 220 (e.g., refer to FIGS. 11 and 13). Opposite end portions of the conductive member 270 may be coupled to the coupling protrusions 2431 of the coupling portion 243, respectively. The conductive member 270 may integrally move with the second support member 240. In an example, the conductive member 270 may move together with the second support member 240 in the sliding directions D1 and D2 when the second support member 240 moves relative to the first support member 220 in the sliding directions D1 and D2, and the position of the conductive member 270 relative to the sensing substrate 260 may vary accordingly. The conductive member 270 may be moved relative to the sensing substrate 260 in the sliding directions D1 and D2 by a sliding operation of the second support member 240 (e.g., the second housing 230).

In another embodiment, the conductive member 270 may be coupled to the coupling portion 243 so as to be rotatable. For example, the conductive member 270 may be coupled to the coupling portion 243 so as to be rotatable about a rotational axis R perpendicular to the sliding directions D1 and D2. The rotational axis R may be substantially parallel to the coupling portion 243. However, this is illustrative, and the conductive member 270 is not limited to being coupled to the coupling portion 243 so as to be rotatable.

The drive member 293 may include the rack gear 294, the pinion gear 295, the motor 296, and a circuit board 297. The pinion gear 295, the motor 296, and the circuit board 297 may be disposed on the fourth surface 242 of the second support member 240. As described above, the rack gear 294 may be fixed to the second surface 222 of the first support member 220.

In another embodiment, the rack gear 294 and the pinion gear 295 may have corresponding bumpy surfaces so as to be engaged and fastened with each other. The pinion gear 295 may be connected with the motor 296 so as to be rotated by the motor 296. A central shaft 2951 of the pinion gear 295 may be connected to the motor 296, and the pinion gear 295 may receive the power of the motor 296 accordingly. The pinion gear 295 may rotate in the clockwise or counterclockwise direction depending on the direction in which the motor 296 operates.

In still another embodiment, the rack gear 294 may linearly move relative to the pinion gear 295 as the pinion gear 295 performs a rotational motion in the state of being fastened to the rack gear 294. When the rack gear 294 is fixed, the pinion gear 295 may move on the rack gear 294 while being rotated by an operation of the motor 296. Based on FIG. 8, the rack gear 294 may be fixed to the first support member 220 (e.g., the first housing 210), and when the motor 296 rotates the pinion gear 295 in the clockwise direction, the pinion gear 295 may move in the second direction D2 while rotating on the rack gear 294 in the clockwise direction, and the second support member 240 (e.g., the second housing 230) may move in the second direction D2 accordingly (e.g., an operation in which the electronic device 200 is changed from the second state S2 to the first state S1 of FIG. 4).

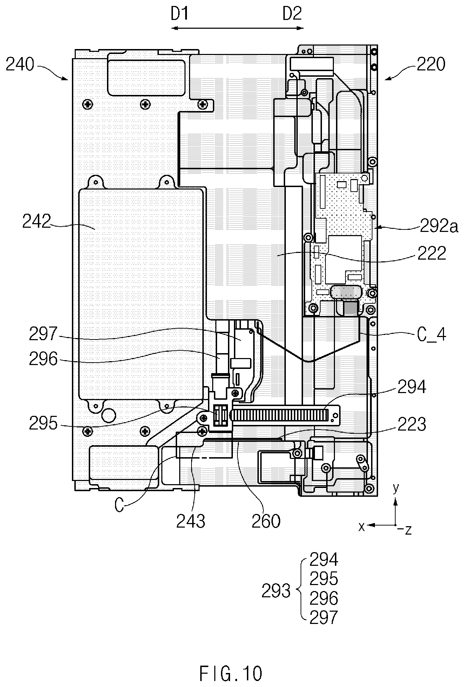

In yet another embodiment, the motor 296 may be electrically connected to the substrate members (e.g., the substrate members 292 of FIG. 6). For example, the motor 296 may be electrically connected to at least one of the substrate members 292 (e.g., the first sub-substrate 292a) and may receive power from the battery of the electronic device 200 (e.g., the first battery 189 of FIG. 1) or may receive a control signal from the processor of the electronic device 200 (e.g., the processor 120 of FIG. 1). The motor 296 may be connected to the circuit board 297 disposed on the second support member 240, and the circuit board 297 may be connected to the first sub-substrate 292a through a connecting member C_4 that extends long (e.g., refer to FIG. 10). In another example, to connect the circuit board 297 and the first sub-substrate 292a even when the distance between the circuit board 297 and the first sub-substrate 292a is varied by sliding of the second support member 240, the connecting member C_4 may be formed to be flexible and may extend long by a certain length.

The moving distance or moving speed of the second support member 240 (or, the second housing 230) may be determined depending on the rotational speed of the motor 296 and the shape (e.g., pitch circle diameter) of the pinion gear 295. For example, the motor 296 may be a step motor including a reduction gear, and the distance that the rack gear 294 (or, the second support member 240) moves per 1 step pulse may be determined based on the phase of the step motor (e.g., a 2-phase step motor or a 5-phase step motor), the pulse per second (PPS) of the step motor, the gear reduction ratio, and the pitch circle diameter of the pinion gear 295, and the time it takes the rack gear 294 to move a specified distance may be determined accordingly.

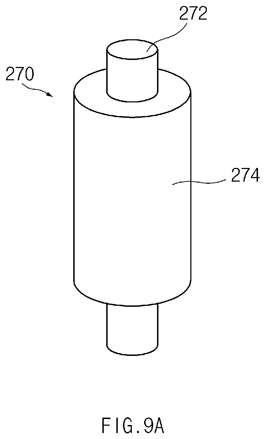

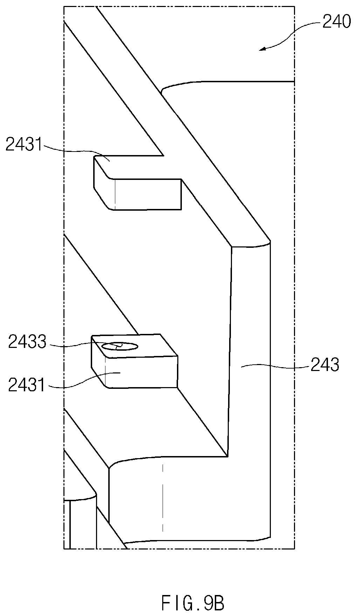

FIG. 9A is a view illustrating a conductive member of an electronic device according to an embodiment of the disclosure. FIG. 9B is a view illustrating a portion of a second support member of an electronic device according to an embodiment of the disclosure.

Referring to FIGS. 9A and 9B, an electronic device 200 according to an embodiment may include a conductive member 270 coupled to a second support member 240.

In an embodiment, the conductive member 270 may be coupled to the coupling portion 243 of the second support member 240. In an example, the opposite end portions of the conductive member 270 may be supported by the coupling protrusions 2431 of the coupling portion 243, and the conductive member 270 may be coupled to the second support member 240 accordingly.

In another embodiment, the conductive member 270 may include a rod 272 coupled to the coupling portion 243 and a conductor 274 coupled to surround the outer circumferential surface of the rod 272.

In yet another embodiment, the rod 272 may extend in a direction perpendicular to the direction of movement of the second support member 240 (e.g., the first direction D1 and the second direction D2), and opposite end portions of the rod 272 may be inserted into and coupled to recesses 2433 formed on the coupling protrusions 2431. For example, the rod 272 may be disposed side by side with the coupling portion 243 while substantially paralleling the coupling portion 243. The rod 272 may have a certain rigidity so as to be stably fixed to the second support member 240.

The conductor 274 may surround at least a portion of the outer circumferential surface of the rod 272. The conductor 274 may be configured to make contact with the sensing substrate (e.g., the sensing substrate 260 of FIGS. 5 and 6) or the sensing pads (not illustrated) disposed on the sensing substrate 260.

In one embodiment, the conductor 274 may include an elastic or compressible material. For example, to alleviate impact caused by contact when the conductor 274 makes contact with the sensing substrate 260 or the sensing pads 280 and to clearly detect contact through close contact, the conductor 274 may be formed of a material having a specified level of elasticity. The conductor 274 may include at least one of conductive rubber, a conductive sponge, conductive silicone, a conductive pad, an elastic material into which a conductive wire is inserted, or an elastic material coated with a conductive material (e.g., a conductive sheet or a conductive fiber). The material of the conductor 274 is not limited to the aforementioned examples.

In an embodiment, the conductive member 270 may be referred to as a conductive roller that is able to entirely or partially rotate relative to the second support member 240. For example, when the second support member 240 moves, the conductive roller 270 may perform a linear motion relative to the sensing substrate 260 while at least a portion of the conductive roller 270 performs a rotational motion. The conductive roller may make contact with the sensing pads 280 while performing a rolling motion on the sensing substrate 260.

The conductive member 270 may be configured such that at least a portion thereof rotates relative to the second support member 240 about the rotational axis (e.g., the rotational axis R of FIG. 7). For example, the conductive member 270 may be formed in a structure in which the rod 272 is coupled to the coupling portion 243 so as to be rotatable and the conductor 274 is coupled to the rod 272 to integrally rotate with the rod 272. When the second support member 240 moves, the rod 272 and the conductor 274 may move while rotating together relative to the sensing substrate 260. In another example, the conductive member 270 may be formed in a structure in which the rod 272 is coupled to the coupling portion 243 so as not to rotate and the conductor 274 is coupled to the rod 272 so as to be rotatable. When the second support member 240 moves, the rod 272 and the conductor 274 may move while only the conductor 274 rotates relative to the sensing substrate 260 without rotation of the rod 272. The conductive member 270 is not necessarily limited to the rotation of at least a portion thereof. For example, the conductive member 270 may be configured to move on the sensing substrate 260 in a state in which the entire conductive member 270 is fixed to the second support member 240 so as not to rotate.

The shape of the conductive member 270 and the coupling structure of the conductive member 270 and the second support member 240 according to the illustrated embodiment are illustrative, and the disclosure is not limited thereto. In various embodiments, the entire conductive member 270 may be formed of one compressible conductor and may be attached to the coupling portion 243 so as to face the sensing substrate 260.

FIG. 10 is a view illustrating a first support member and a second support member of an electronic device according to an embodiment of the disclosure. FIG. 11 is a view illustrating a contact structure between a sensing substrate and a conductive member of an electronic device according to an embodiment of the disclosure.

FIG. 10 is a view illustrating a first support member 220 and a second support member 240 as viewed in a rear direction of an electronic device 200 (e.g., the -z-axis direction). For example, FIG. 10 may be a top view illustrating a second surface 222 of the first support member 220 and a fourth surface 242 of the second support member 240 when the electronic device 200 is in a second state S2.

FIG. 11 is a view illustrating a portion corresponding to portion C of FIG. 10 and is a view in which the first support member 220 is omitted.

Referring to FIGS. 10 and 11, the electronic device according to an embodiment (e.g., the electronic device 200 of FIGS. 2 to 4) may include the first support member 220, the second support member 240, the sensing substrate 260, the conductive member 270, and the drive member 293.

The first support member 220 may be one component of the first housing (e.g., the first housing 210 of FIGS. 2 to 4), and the second support member 240 may be one component of the second housing (e.g., the second housing 230 of FIGS. 2 to 4). The second support member 240 may be configured to move relative to the first support member 220 in the first direction D1 and the second direction D2 in a state of partially overlapping the first support member 220. FIG. 10 illustrates an arrangement of the first support member 220 and the second support member 240 when the electronic device 200 is in the second state S2 and may correspond to a state in which the second support member 240 is located as far as possible from the first support member 220 in the first direction D1. When the second support member 240 moves in the second direction D2 based on FIG. 10, the electronic device 200 may be changed to the first state S1.

In another embodiment, the first support member 220 and the second support member 240 may be disposed to overlap each other such that the second surface 222 of the first support member 220 and the fourth surface 242 of the second support member 240 face in the same direction. In an example, the second surface 222 of the first support member 220 may partially face the opposite surface (e.g., the third surface 241 of FIG. 7) that faces away from the fourth surface 242 of the second support member 240. Since the first support member 220 and the second support member 240 are disposed to overlap each other, the fixed portion 223 (e.g., the fixed portion 223 of FIGS. 5 and 6) of the first support member 220 and the coupling portion 243 (e.g., the coupling portion 243 of FIGS. 7 and 8) of the second support member 240 may face each other. The fixed portion 223 and the coupling portion 243 may be substantially perpendicular to the opposite surfaces of the first support member 220 and the opposite surfaces of the second support member 240.

In still another embodiment, the sensing substrate 260 may be disposed on the fixed portion 223 of the first support member 220. The sensing substrate 260 may be fixed to the first support member 220 and may integrally move with the first support member 220. The sensing substrate 260 may extend in the sliding directions D1 and D2 and may be disposed such that opposite surfaces thereof face in a direction (e.g., the y-axis direction) perpendicular to the sliding directions D1 and D2 (e.g., the x-axis direction). The sensing substrate 260 may be disposed such that one surface (e.g., a surface facing in the +y-axis direction) is bonded to the fixed portion 223 and an opposite surface 263 (e.g., a surface facing in the -y-axis direction) faces toward the coupling portion 243 of the second support member 240. The sensing pads 280 may be disposed on the opposite surface 263 (i.e., second surface 243) of the sensing substrate 260. The sensing pads 280 may be configured as conductive pad regions formed on at least a portion of the opposite surface 263 of the sensing substrate 260.

In yet another embodiment, the conductive member 270 may be disposed on the coupling portion 243 of the second support member 240. When the second support member 240 moves, the conductive member 270 may move relative to the first support member 220 and the sensing substrate 260 in the first direction D1 and the second direction D2 together with the second support member 240. Since the fixed portion 223 of the first support member 220 and the coupling portion 243 of the second support member 240 are disposed to face each other, the conductive member 270 may be brought into contact with the sensing substrate 260 (or, the sensing pads 280). For example, the conductive member 270 may be brought into contact with the opposite surface (e.g., the surface facing in the -y-axis direction) of the sensing substrate 260 or the sensing pads 280. The conductive member 270 may move relative to the sensing substrate 260 in the first direction D1 and the second direction D2 in the state in which at least a portion of the conductive member 270 is brought into contact with the sensing substrate 260 or the sensing pads 280. As described above, the conductive member 270 may be coupled to the coupling portion 243 so as to be rotatable. The conductive member 270 may move while being rotated by a frictional force resulting from the contact with the sensing substrate 260 (or, the sensing pads 280).

According to an embodiment of the disclosure, the sensing substrate 260 and the conductive member 270 may be disposed substantially perpendicular to the front surface (e.g., the surface facing in the +z-axis direction) or the rear surface (e.g., the surface facing in the -z-axis direction) of the electronic device 200. The space occupied in the lengthwise direction of the electronic device 200 (e.g., the y-axis direction) may be reduced, and thus a mounting structure optimized in the lengthwise direction may be provided. In addition, when an external force is applied in the direction (the z-axis direction) perpendicular to the front or rear surface of the electronic device 200 (e.g., when a user presses the display), the external force may be prevented from affecting the contact between the sensing substrate 260 and the conductive member 270.

The drive member 293 may provide a driving force to move the second support member 240 relative to the first support member 220. The drive member 293 may include the rack gear 294, the pinion gear 295, the motor 296, and the circuit board 297. The rack gear 294 may be coupled to the first support member 220, and the pinion gear 295 and the motor 296 may be coupled to the second support member 240. The pinion gear 295 may be connected to the motor 296 to receive the power of the motor 296 and may be engaged with the rack gear 294. The pinion gear 295 may move in the first direction D1 and the second direction D2 while being rotated on the rack gear 294 by an operation of the motor 296. Accordingly, the pinion gear 295 may move the second support member 240 relative to the first support member 220 in the first direction D1 and the second direction D2.

In another embodiment, the motor 296 may be electrically connected to the first sub-substrate 292a, which is fixed to the first support member 220, through the circuit board 297 and the connecting member C_4. The connecting member C_4 may be formed of a flexible material and may extend long. When the second support member 240 moves, the connecting member C_4 may be partially deformed in response to a change in the relative positions between the motor 296 and the first sub-substrate 292a.

FIG. 12 is a view illustrating a sensing substrate and sensing pads of an electronic device according to an embodiment of the disclosure. FIG. 13 is a view illustrating a contact structure between sensing pads and a conductive member of an electronic device according to an embodiment of the disclosure.

Referring to FIGS. 12 and 13, an electronic device 200 according to an embodiment may include a sensing substrate 260, sensing pads 280 disposed on a sensing substrate 260, and a conductive member 270 configured to make contact with at least a part of the sensing pads 280 while moving on the sensing substrate 260.

The sensing substrate 260 may include a first surface 261 coupled (or, attached) to the fixed portion 223 of the first support member 220 and a second surface 263 facing away from the first surface 261 and facing the coupling portion 243 of the second support member 240. The sensing pads 280 may be disposed on the second surface 263 of the sensing substrate 260.

In another embodiment, the conductive member 270 may be configured such that when the state of the electronic device 200 is changed, the conductor 274 is brought into contact with at least a part of the sensing pads 280 while moving relative to the sensing substrate 260 in the sliding directions D1 and D2. The conductive member 270 may be brought into electrical contact with at least a part of the sensing pads 280.

In yet another embodiment, the sensing pads 280 may be disposed on the second surface 263 of the sensing substrate 260 so as to face toward the coupling portion 243. The sensing pads 280 may be spaced apart from each other in the sliding directions D1 and D2 on the second surface 263. The sensing pads 280 may be configured such that at least one pad set is brought into contact with the conductive member 270 as the conductive member 270 moves relative to the sensing substrate 260 in the sliding directions D1 and D2. Each of the sensing pads 280 may include a plurality of sub-pads, and the plurality of sub-pads may be connected with at least one signal line. For example, the sensing pad 280 may be operatively connected with the processor of the electronic device 200 (e.g., the processor 120 of FIG. 1) through the signal line.

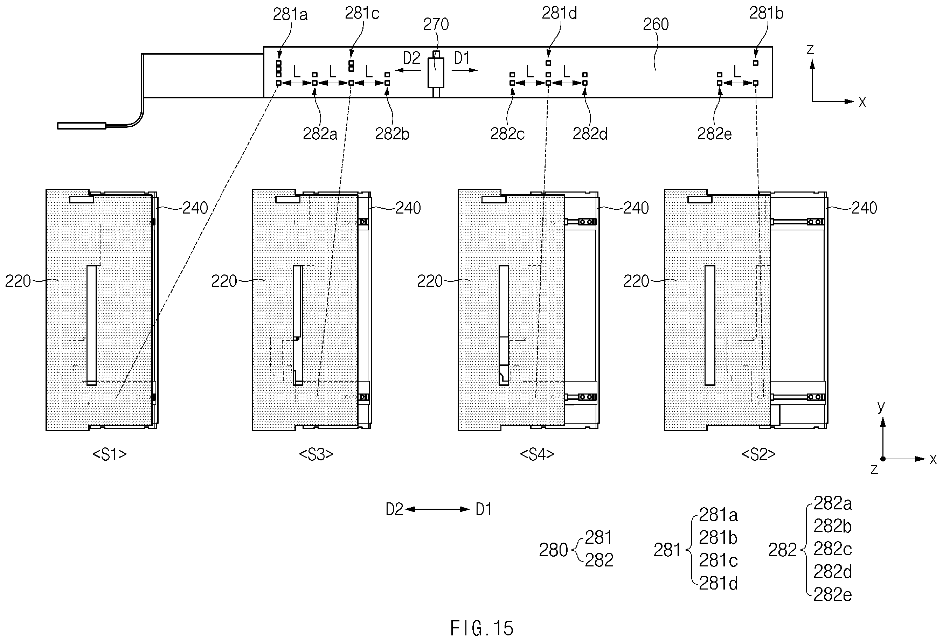

In an embodiment, on the second surface 263, the sensing pads 280 may be disposed at positions corresponding to a plurality of states of the electronic device 200. In an example, among the sensing pads 280, some pad sets may be disposed at positions brought into contact with the conductive member 270 when the electronic device 200 is in the first state (e.g., the first state S1 of FIGS. 1 and 3) and other pad sets may be disposed at positions brought into contact with the conductive member 270 when the electronic device 200 is in the second state (e.g., the second state S2 of FIGS. 1 and 3) The electronic device 200 may be configured to recognize the state of the electronic device 200 by sensing contact between one pad set among the sensing pads 280 and the conductive member 270. A method of recognizing the state of the electronic device 200 through contact between the conductive member 270 and the sensing pads 280 will be described below with reference to FIGS. 14 and 15.

The sensing pads 280 may include a plurality of position pads 281 corresponding to the plurality of states (e.g., the first to fourth states S1 to S4) of the electronic device 200 and a plurality of pre-position pads 282 spaced apart from the plurality of position pads 281 by a certain distance. Each of the plurality of position pads 281 and the plurality of pre-position pads 282 may be formed in the form of a pad set including a plurality of sub-pads arranged in a direction perpendicular to the sliding directions. For example, the pad sets included in the plurality of position pads 281 and the plurality of pre-position pads 282 may have a form in which the plurality of sub-pads are disposed on the sensing substrate 260 in the direction perpendicular to the sliding directions D1 and D2. The conductive member 270 may extend long in the direction perpendicular to the sliding directions D1 and D2 so as to make contact with the pad sets.

In one embodiment, the sensing pads 280 may be formed in a protruding shape. For example, the sensing pads 280 may be formed in a shape protruding from the second surface 263 of the sensing substrate 260 by a certain height. Each of the sensing pads 280 may include a pad layer 280a disposed on the second surface 263 of the sensing substrate 260 and a protruding member 280b disposed on the pad layer 280a.

In another embodiment, the pad layer 280a may be disposed on a partial region of the second surface 263 so as to form substantially the same surface as the second surface 263. The pad layer 280a may refer to a conductive layer or a conductive region formed on the second surface 263. The pad layer 280a may be connected with a signal line and may be operatively connected with the processor 120 of the electronic device 200 through the signal line.

In still another embodiment, the protruding member 280b may be disposed on the pad layer 280a so as to be electrically connected with the pad layer 280a. For example, the protruding member 280b may be formed of a conductive material and may be mounted on the pad layer 280a using surface mounting technology (SMT). However, the disclosure is not limited thereto. The protruding member 280b may make contact with the conductive member 270 and may electrically connect the conductive member 270 and the pad layer 280a. Corner portions of the protruding member 280b that face in the sliding directions D1 and D2 may have a rounded shape to facilitate movement of the conductive member 270.

According to the illustrated embodiment, since the sensing pads 280 include the protruding members 280b so as to have a protruding shape, the sensing pads 280 may be brought into contact with the conductor 274 of the conductive member 270, which has elasticity, while partially overlapping the conductor 274. Whether the sensing pads 280 are brought into contact with the conductor 274 may be clearly sensed. However, the illustrated embodiment is illustrative, and the shape of the sensing pads 280 is not limited thereto. The sensing pads 280 may be formed in a flat shape rather than the protruding shape. Each of the sensing pads 280 may include only the pad layer 280a so as to form the same plane as the second surface 263 of the sensing substrate 260, and the pad layer 280a may be brought into direct contact with the conductor 274.

FIG. 14 a view illustrating an operation in which a state of an electronic device is changed according to an embodiment of the disclosure. FIG. 15 is a view illustrating positions of sensing pads corresponding to a plurality of states of an electronic device according to an embodiment of the disclosure.

Referring to FIGS. 14 and 15, an electronic device 200 according to an embodiment may include a first housing 210 including a first support member 220, a second housing 230 including a second support member 240, a display 250 including an exposed region, the area of which is varied depending on movement of the second housing 230, a sensing substrate 260 disposed on the first support member 220, a conductive member 270 disposed on the second support member 240, and sensing pads 280 disposed on the sensing substrate 260.

In an embodiment, the electronic device 200 may be configured such that the state of the electronic device 200 is changed as the second housing 230 slides relative to the first housing 210 in the first direction D1 or the second direction D2. The plurality of states of the electronic device 200 may include the first state S1 that is a closed state, the second state S2 that is a fully open state, and one or more intermediate states S3 and S4 that are partially open states between the first state S1 and the second state S2. In an example, the one or more intermediate states S3 and S4 may include the third state S3 between the first state S1 and the second state S2 and the fourth state S4 between the third state S3 and the second state S2. However, without being limited to the illustrated embodiment, the intermediate states S3 and S4 may include only one of the third state S3 and the fourth state S4, or may additionally include other intermediate states (e.g., a fifth state, a sixth state, or a seventh state).

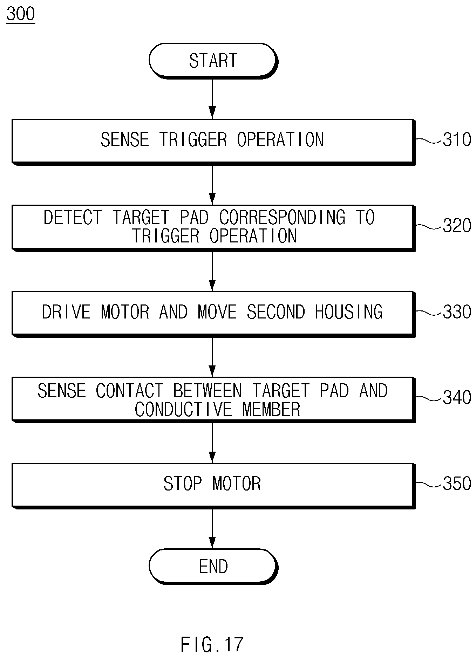

In another embodiment, the electronic device 200 may sense a certain operation (e.g., a trigger operation) input to the electronic device 200 and may be changed from one of the first to fourth states S1 to S4 to another state. For example, the electronic device 200 may be directly changed from the first state S1 to one of the second state S2, the third state S3, and the fourth state S4, or may be directly changed from the second state S2 to one of the first state S1, the third state S3, and the fourth state S4. An operation for changing the state of the electronic device 200 will be described below with reference to FIG. 17.

In yet another embodiment, the exposed region of the display 250 may have different sizes depending on the states of the electronic device 200. The exposed region of the display 250 may refer to a partial region of the display 250 exposed outside the electronic device 200 or on the front surface (e.g., the surface facing in the +z-axis direction) of the electronic device 200. The area (or, width) of the exposed region may be variable in response to the state of the electronic device 200. When the second housing 230 slides relative to the first housing 210 in the first direction D1 based on the first state S1, the size of the exposed region of the display 250 may be extended. When the second housing 230 slides relative to the first housing 210 in the second direction D2 based on the second state S2, the size of the exposed region of the display 250 may be reduced.

The exposed region of the display 250 may be extended or reduced as the second region 254 is withdrawn from the second housing 230 (e.g., slide-out) or inserted into the second housing 230 (e.g., slide-in) by sliding of the second housing 230. For example, the exposed region in the first state S1 may be substantially the same as the first region 252 of the display 250. The exposed region in the second state S2, the third state S3, or the fourth state S4 may be formed by the first region 252 and at least a portion of the second region 254 of the display 250.

In another embodiment, the exposed region of the display 250 may have a minimum area (or, size) when the electronic device 200 is in the first state S1 and may have a maximum area when the electronic device 200 is in the second state S2. The exposed region of the display 250 may have an intermediate area between the area in the first state S1 and the area in the second state S2 when the electronic device 200 is in the intermediate states S3 and S4. The exposed region of the display 250 may be extended or reduced while the width is varied depending on movement of the second housing 230, with the length constant. The width may be the distance measured in a direction (e.g., the x-axis direction) parallel to the sliding directions D1 and D2 of the second housing 230, and the length may be the distance measured in a direction (e.g., the y-axis direction) perpendicular to the sliding directions D1 and D2.

In yet another embodiment, when the electronic device 200 is in the first state S1, the width (or, area) of the exposed region may be a first width W1 (or, a first area). When the electronic device 200 is in the second state S2, the width of the exposed region may be a second width W2 (or, a second area) greater than the first width W1. When the electronic device 200 is in the third state S3, the width of the exposed region may be a third width W3 (or, a third area) greater than the first width W1 and smaller than the second width W2. When the electronic device 200 is in the fourth state S4, the width of the exposed region may be a fourth width W4 (or, a fourth area) greater than the third width W3 and smaller than the second width W2. For example, the screen aspect ratio (e.g., the ratio of the length to the width) of the display 250 may be about 20:9 in the first state S1, about 18:9 in the third state S3, about 16:9 in the fourth state S4, and about 4:3 in the second state S2, but is not limited thereto.

As the conductive member 270 moves relative to the first support member 220 together with the second support member 240, the conductive member 270 may reciprocate in the first direction D1 and the second direction D2 on the sensing substrate 260 fixed to the first support member 220. For example, in an operation in which the electronic device 200 (or, the display 250) is extended (e.g., in an operation in which the electronic device 200 is changed from the first state S1 to the second state S2), the conductive member 270 may move relative to the sensing substrate 260 in the first direction D1 as the second support member 240 moves relative to the first support member 220 in the first direction D1. In contrast, in an operation in which the electronic device 200 (or, the display 250) is reduced (e.g., in an operation in which the electronic device 200 is changed from the second state S2 to the first state S1), the conductive member 270 may move relative to the sensing substrate 260 in the second direction D2 as the second support member 240 moves relative to the first support member 220 in the second direction D2. The conductive member 270 may be configured to make contact with one pad set among the sensing pads 280 while moving on the sensing substrate 260 in response to the state of the electronic device 200.

In one embodiment, the sensing pads 280 may include the plurality of position pads 281 corresponding to the plurality of states (e.g., the first to fourth states S1 to S4) of the electronic device 200. For example, on the sensing substrate 260, the plurality of position pads may be disposed at positions brought into contact with the conductive member 270 depending on the states of the electronic device 200.

In another embodiment, the plurality of position pads 281 may include a first pad set 281a corresponding to the first state S1, a second pad set 281b corresponding to the second state S2, a third pad set 281c corresponding to the third state S3, and a fourth pad set 281d corresponding to the fourth state S4. The first to fourth pad sets 281a to 281d may be disposed at specified positions on the sensing substrate 260 and may be spaced apart from each other in the sliding directions D1 and D2. The first pad set 281a, the third pad set 281c, the fourth pad set 281d, and the second pad set 281b disposed on the sensing substrate 260 may be sequentially arranged on the sensing substrate 260 in the first direction D1. The number of position pads 281 is not limited to the illustrated embodiment, and when the electronic device 200 further includes additional intermediate states (e.g., the fifth state and the sixth state), the plurality of position pads 281 may further include additional pad sets (e.g., a fifth pad set and a sixth pad set).

In still another embodiment, the first pad set 281a may be disposed at a position brought into contact with the conductive member 270 when the electronic device 200 is in the first state S1. The second pad set 281b may be disposed at a position brought into contact with the conductive member 270 when the electronic device 200 is in the second state S2. The third pad set 281c may be disposed at a position brought into contact with the conductive member 270 when the electronic device 200 is in the third state S3. The fourth pad set 281d may be disposed at a position brought into contact with the conductive member 270 when the electronic device 200 is in the fourth state S4. For example, the plurality of position pads 281 may be configured such that when the sensing substrate 260 is viewed from above, the first pad set 281a overlaps the conductive member 270 in the first state S1, the second pad set 281b overlaps the conductive member 270 in the second state S2, the third pad set 281c overlaps the conductive member 270 in the third state S3, and the fourth pad set 281d overlaps the conductive member 270 in the fourth state S4.

The electronic device 200, according to an embodiment, may recognize the state of the electronic device 200 by sensing contact (or, electrical contact) between the conductive member 270 and the plurality of position pads 281. For example, the electronic device 200 may recognize that the electronic device 200 is in the first state S1, by sensing contact between the conductive member 270 and the first pad set 281a. The electronic device 200 may recognize that the electronic device 200 is in the second state S2, by sensing contact between the conductive member 270 and the second pad set 281b. The electronic device 200 may recognize that the electronic device 200 is in the third state S3, by sensing contact between the conductive member 270 and the third pad set 281c. The electronic device 200 may, for example, recognize that the electronic device 200 is in the fourth state S4, by sensing contact between the conductive member 270 and the fourth pad set 281d.

In an embodiment, the sensing pads 280 may further include the plurality of pre-position pads 282. The plurality of pre-position pads 282 may be configured to make contact with the conductive member 270 in a section between one state and another state before a change of state of the electronic device 200 is completed. The plurality of pre-position pads 282 may be disposed between the plurality of position pads 281 located adjacent to each other. In an example, the plurality of pre-position pads 282 may be disposed at positions spaced apart from the plurality of position pads 281 by a specified distance in the first direction D1 or the second direction D2.

In another embodiment, the plurality of pre-position pads 282 may include a first pre-pad set 282a disposed between the first pad set 281a and the third pad set 281c, a third pre-pad set 282b and a fourth pre-pad set 282c disposed between the third pad set 281c and the fourth pad set 281d, and a fifth pre-pad set 282d and a second pre-pad set 282e disposed between the fourth pad set 281d and the second pad set 281b. For example, the first pad set 281a, the first pre-pad set 282a, the third pad set 281c, the third pre-pad set 282d, the fourth pre-pad set 282c, the fourth pad set 281d, the fifth pre-pad set 282d, the second pre-pad set 282e, and the second pad set 281b may be sequentially arranged on the sensing substrate 260 in the first direction D1.

In still another embodiment, the first pre-pad set 282a may be brought into contact with the conductive member 270 at a certain point in a deformation section between the first state S1 and the third state S3. The third pre-pad set 282b and the fourth pre-pad set 282c may be brought into contact with the conductive member 270 at different points in a deformation section between the third state S3 and the fourth state S4. For example, the third pre-pad set 282b may be brought into contact with the conductive member 270 at a point close to the third state S3, and the fourth pre-pad set 282c may be brought into contact with the conductive member 270 at a point close to the fourth state S4. The fifth pre-pad set 282d and the second pre-pad set 282e may be brought into contact with the conductive member 270 at different points in a deformation section between the fourth state S4 and the second state S2. For example, the fifth pre-pad set 282d may be brought into contact with the conductive member 270 at a point close to the fourth state S4, and the second pre-pad set 282e may be brought into contact with the conductive member 270 at a point close to the second state S2.

The plurality of pre-position pads 282 may be disposed at positions spaced a certain distance L apart from the plurality of position pads 281 disposed adjacent thereto. The first pre-pad set 282a may be disposed at a position spaced apart from the first pad set 281a by the first distance L in the first direction D1 and spaced apart from the third pad set 281c by the first distance L in the second direction D2. The third pre-pad set 282b may be disposed at a position spaced apart from the third pad set 281c by the first distance L in the first direction D1. The fourth pre-pad set 282c may be disposed at a position spaced apart from the fourth pad set 281d by the first distance L in the second direction D2. The fifth pre-pad set 282d may be disposed at a position spaced apart from the fourth pad set 281d by the first distance L in the first direction D1. The second pre-pad set 282e may be disposed at a position spaced apart from the second pad set 281b by the first distance L in the second direction D2. For example, the first distance L may be a length obtained by measuring the distances between the centers of the plurality of position pads 281 and the centers of the plurality of pre-position pads 282 in the sliding directions D1 and D2.

By sensing contact (or, electrical contact) between the conductive member 270 and the plurality of pre-position pads 282, the electronic device 200 according to an embodiment may recognize the moving distance and the direction of movement of the second housing 230 (or, the conductive member 270) required for the electronic device 200 to complete a change to a specific state among the first to fourth states S1 to S4. The electronic device 200 may accurately recognize the current state of the electronic device 200 through the plurality of pre-position pads 282 and may precisely perform control of the drive member 293 for changing the state of the electronic device 200.

The first pre-pad set 282a may enable the electronic device 200 to sense contact between the conductive member 270 and the first pre-pad set 282a and recognize that a change to the first state S1 is to be completed when the conductive member 270 is moved in the second direction D2 by the first distance L and a change to the third state S3 is to be completed when the conductive member 270 is moved in the first direction D1 by the first distance L.

For example, the third pre-pad set 282b may enable the electronic device 200 to sense contact between the conductive member 270 and the third pre-pad set 282b and recognize that a change to the third state S3 is to be completed when the conductive member 270 is moved in the second direction D2 by the first distance L.

In another example, the fourth pre-pad set 282c may enable the electronic device 200 to sense contact between the conductive member 270 and the fourth pre-pad set 282c and recognize that a change to the fourth state S4 is to be completed when the conductive member 270 is moved in the first direction D1 by the first distance L.

For example, the fifth pre-pad set 282d may enable the electronic device 200 to sense contact between the conductive member 270 and the fifth pre-pad set 282d and recognize that a change to the fourth state S4 is to be completed when the conductive member 270 is moved in the second direction D2 by the first distance L.

In yet another example, the second pre-pad set 282e may enable the electronic device 200 to sense contact between the conductive member 270 and the second pre-pad set 282e and recognize that a change to the second state S2 is to be completed when the conductive member 270 is moved in the first direction D1 by the first distance L.

Each of the pad sets included in the plurality of position pads 281 and the plurality of pre-position pads 282 may include a plurality of sub-pads. For example, the plurality of position pads 281 and the plurality of pre-position pads 282 may be formed in a form in which the plurality of sub-pads are arranged in a row on the sensing substrate 260 in a direction (e.g., the z-axis direction) perpendicular to the sliding directions D1 and D2. The plurality of position pads 281 and the plurality of pre-position pads 282 may be configured such that when the conductive member 270 makes contact with one pad set (e.g., the first to fourth pad sets 281a to 281d or the first to fifth pre-pad sets 282a to 282d), all of the plurality of sub-pads included in the corresponding pad set are brought into contact with the conductive member 270.

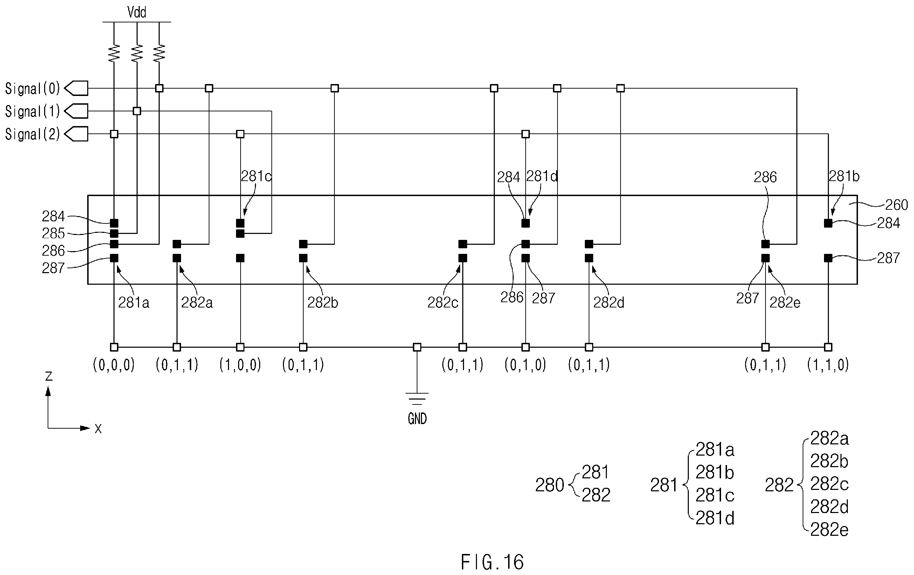

FIG. 16 is a view illustrating a circuit configuration of sensing pads of an electronic device according to an embodiment of the disclosure.

Referring to FIG. 16, sensing pads 280 may include a plurality of position pads 281 and a plurality of pre-position pads 282. Each of the plurality of position pads 281 and the plurality of pre-position pads 282 may be connected with at least one signal line. For example, the sensing pads 280 may be operatively connected with a processor 120 of an electronic device 200 through signal lines, and the processor 120 may sense a signal and a change in the signal due to contact between a conductive member 270 and the sensing pads 280.

In one embodiment, each of the plurality of position pads 281 and the plurality of pre-position pads 282 may include a plurality of sub-pads 284 to 287. For example, the plurality of sub-pads 284 to 287 may include the first sub-pad 284, the second sub-pad 285, the third sub-pad 286, and the fourth sub-pad 287. The plurality of sub-pads 284 to 287 may be arranged on the sensing substrate 260 in a direction (e.g., the z-axis direction) perpendicular to the sliding directions (e.g., the x-axis direction). For example, the first sub-pad 284, the second sub-pad 285, the third sub-pad 286, and the fourth sub-pad 287 may be disposed in a row in the lengthwise direction of the conductive member 270 so as to be brought into contact with the conductive member (e.g., the conductive member 270 of FIG. 15).

In another embodiment, the plurality of position pads 281 and the plurality of pre-position pads 282 may include at least one of the first sub-pad 284, the second sub-pad 285, the third sub-pad 286, or the fourth sub-pad 287. For example, each of the plurality of position pads 281 and the plurality of pre-position pads 282 may include two or more sub-pads. The pad sets of the plurality of position pads 281 and the plurality of pre-position pads 282 may be configured such that two or more sub-pads among the first sub-pad 284, the second sub-pad 285, the third sub-pad 286, and the fourth sub-pad 287 form one set.

In still another embodiment, the pad sets of the plurality of position pads 281 may be configured such that two or more sub-pads form one set in different combinations. For example, the first pad set 281a may include the first sub-pad 284, the second sub-pad 285, the third sub-pad 286, and the fourth sub-pad 287. The second pad set 281b may include the first sub-pad 284 and the fourth sub-pad 287. The third pad set 281c may include the first sub-pad 284, the second sub-pad 285, and the fourth sub-pad 287. The fourth pad set 281d may include the first sub-pad 284, the third sub-pad 286, and the fourth sub-pad 287.

In yet another embodiment, the pad sets of the plurality of pre-position pads 282 may be configured such that two or more sub-pads form one set in the same combination. For example, each of the first to fifth pre-pad sets 282a to 282d may include the third sub-pad 286 and the fourth sub-pad 287. The number and types of sub-pads constituting the pad sets of the plurality of position pads 281 and the plurality of pre-position pads 282 are not limited to the illustrated embodiment and may be changed in various combinations.

In an embodiment, the plurality of sub-pads 284 to 287 may be configured such that the first sub-pads 284, the second sub-pads 285, the third sub-pads 286, or the fourth sub-pads 287 that constitute the respective pad sets are disposed side by side in a direction parallel to the sliding directions (e.g., the x-axis direction). In an example, the fourth sub-pads 287 included in the first to fourth pad sets 281a to 281d and the first to fifth pre-pad sets 282a to 282d may be located on the same line in the sliding directions. In another example, the first sub-pads 284 included in the first to fourth pad sets 281a to 281d may be located on the same line in the sliding directions. For example, the second sub-pads 285 included in the first pad set 281a and the third pad set 281c may be located on the same line in the sliding directions.

In an embodiment, the plurality of sub-pads 284 to 287 may be configured as a pull-up circuit. The first to third sub-pads 284 to 286 may be connected to a power supply (e.g., a Vdd power supply), and the fourth sub-pad 287 may be connected to a ground GND. The first to third sub-pads 284 to 286 may be pulled up to the same voltage as that of the power supply, and 1 (High) may be recognized at input pins (e.g., Signal(0), Signal(1), and Signal(2)) that are connected with the first to third sub-pads 284 to 286, respectively. When the plurality of sub-pads 284 to 287 are brought into contact with the conductive member 270, the first sub-pad 284, the second sub-pad 285, and the third sub-pad 286 may be electrically connected with the fourth sub-pad 287 through the conductive member 270, and Vdd power may flow toward the ground. The first to third sub-pads 284 to 286 in the pull-up state may be connected with the ground and may be changed to a pull-down state, and 0 (Low) may be recognized at the input pins (e.g., Signal(0), Signal(1), and Signal(2)) that are connected with the first to third sub-pads 284 to 286, respectively. Without being limited to the illustrated embodiment, the plurality of sub-pads 284 to 287 may be configured as a pull-down circuit.

The first sub-pad 284 may be connected with the third input pin Signal(2), the second sub-pad 285 may be connected with the second input pin Signal(1), and the third sub-pad 286 may be connected with the first input pin Signal(0). The first to third input pins Signal(0), Signal(1), and Signal(2) may be connected with the processor 120 of the electronic device 200, and the processor 120 may determine the current state of the electronic device 200 or the current position of the conductive member 270, based on the values (e.g., 0 (Low) or 1 (High)) recognized at the first to third input pins Signal(0), Signal(1), and Signal(2).

In another embodiment, depending on the states of the electronic device 200, combinations of signals (e.g., 0 (Low) or 1 (High)) recognized at the first input pin Signal(0), the second input pin Signal(1), and the third input pin Signal(3) may differ from one another. The processor 120 may recognize different signal combinations (the order of Signal(0), Signal(1), and Signal(2)) as the conductive member 270 makes contact with the sensing pads 280 corresponding to the states of the electronic device 200.

According to the embodiment illustrated in FIG. 16, combinations of signals (e.g., 0 (Low) or 1 (High)) recognized at the first input pin Signal(0), the second input pin Signal(1), and the third input pin Signal(3) in response to the states of the electronic device 200 may be set as in Table 1 below.

**Table 1**

| State | Signal(0) | Signal(1) | Signal(2) |
|---|---|---|---|
| First state (closed) | 0 | 0 | 0 |
| Second state (open) | 1 | 1 | 0 |
| Third state (auto stop1) | 1 | 0 | 0 |
| Fourth state (auto stop2) | 0 | 1 | 0 |
| Contact with pre-position pad | 0 | 1 | 1 |
| Non-contact with sensing pad | 1 | 1 | 1 |
| Additional state is definable. | 0 | 0 | 1 |
| Additional state is definable. | 1 | 0 | 1 |

Referring to Table 1 above, for example, the processor 120 may determine the current state (e.g., the first to fourth states) of the electronic device 200 by recognizing (0, 0, 0) when the conductive member 270 makes contact with the first pad set 281a, recognizing (1, 0, 0) when the conductive member 270 makes contact with the third pad set 281c, recognizing (0, **1,** 0) when the conductive member 270 makes contact with the fourth pad set 281d, and recognizing (1, **1,** 0) when the conductive member 270 makes contact with the second pad set 281b. By recognizing (0, **1,** 1) when the conductive member 270 makes contact with the first to fifth pre-pad sets 282a to 282d, the processor 120 may determine which of the first to fourth states the electronic device 200 is to be changed to and may determine the moving distance required to complete the change of state (e.g., the first distance L of FIG. 15). In addition, by recognizing (1, **1,** 1) when the conductive member 270 is located between the sensing pads 280 without making contact with the sensing pads 280, the processor 120 may determine that the conductive member 270 is moving toward one of the sensing pads 280. The electronic device 200 may define additional states in which (0, 0, 1) and (1, 0, 1) in Table 1 above are recognized. For example, the electronic device 200 may additionally include pad sets (e.g., the fifth pad set (not illustrated) or the sixth pad set (not illustrated)) through which the processor 120 recognizes (0, 0, 1) and (1, 0, 1) when the conductive member 270 makes contact with the pad sets, and the pad sets may be disposed at positions corresponding to the fifth state (e.g., auto stop3) and the sixth state (e.g., auto stop4) of the electronic device. The number of input pins and the signal combinations are illustrative, and the disclosure is not limited to the above-described contents. According to various embodiments, when input pins (or, signals) are added, signal combinations corresponding to more states may be defined. According to one embodiment, the electronic device 200 may determine the current state of the electronic device 200 or the degree of extension of the display 250 through the current signal recognized by the processor 120 and the order of signal change. When the electronic device 200 is changed from the first state S1 to the second state S2, the signal may be changed in the order of (0, 0, 0), (0, 1, 1), (1, 0, 0), (0, 1, 1), (0, 1, 0), (0, 1, 1), and (1, 1, 0), and when the conductive member 270 is moving without reaching the plurality of position pads 281 or the plurality of pre-position pads 282, the signal may have the value (1, 1, 1). When the signal is sequentially changed to (0, 0, 0), (0, 1, 1), (1, 0, 0), and (0, 1, 1) and then maintained at the value (1, 1, 1), the processor 120 may approximately determine that the conductive member 270 is located between the third pre-pad set 282b and the fourth pre-pad set 282c in a process of moving from the first pad set 281a toward the second pad set 281b.

FIG. 17 is a flowchart illustrating an operating method of an electronic device according to an embodiment of the disclosure.

FIG. 17 is a flowchart illustrating an operation in which an electronic device (e.g., an electronic device 200 of FIGS. 2 to 4 and 14) is changed from one state to another state. In describing FIG. 17, operations of the electronic device may be understood as operations of a control circuit (e.g., the processor 120 of FIG. 1), and the following description will be made with reference to FIG. 17 together with FIGS. 14 and 15.

Referring to FIG. 17, the operating method 300 of the electronic device according to an embodiment may include operation 310 of sensing a trigger operation, operation 320 of detecting a target pad corresponding to the trigger operation, operation 330 of driving the motor and moving the second housing, operation 340 of sensing contact between the target pad and the conductive member, and operation 350 of stopping the motor.

In operation 310, the processor 120 may sense the trigger operation for changing the electronic device 200 to a specific state. For example, the processor 120 may recognize a trigger operation corresponding to a state to which the electronic device 200 is to be changed and may change the electronic device 200 to the corresponding state. The trigger operation may refer to an operation for extending or reducing the display 250 by moving the second housing 230. The trigger operation may, for example, include an operation input by a user, an operation in which the electronic device is placed in a specific situation, and an operation corresponding to an operation of the electronic device. For example, the trigger operation may include operations previously set by the user of the electronic device 200.

In operation 310, the trigger operation may include an operation of touching the display 250, an operation of swiping the display 250, an operation of pressing a physical key (or, button) of the electronic device 200, an operation of pulling or pushing the second housing 230 of the electronic device 200 in one direction, or an operation of wrapping or sweeping one side surface of the electronic device 200 with a hand. The trigger operation may include an operation of touching a soft key or an icon displayed on the display 250. The processor 120 may display icons corresponding to respective states of the electronic device 200 on the display 250 and may determine which of the icons a touch input is applied to. The trigger operation may include an operation of swiping the display 250 in the sliding directions D1 and D2. For example, the processor 120 may determine a swipe input applied to the display 250, the direction of the swipe input (e.g., the first direction D1 and the second direction D2), or the time of the swipe input (e.g., the swipe length) and may change the state of the electronic device 200 in response to the determination. The trigger operation may include an operation of executing a specific application. For another example, when the specific application is executed, the processor 120 may recognize the execution of the specific application as the trigger operation and may change the state of the electronic device 200 in response to a screen aspect ratio optimized for the execution of the specific application. The trigger operation is not limited to the above-described examples and may be implemented in various ways.

In operation 320, the processor 120 may determine the state of the electronic device 200 that corresponds to the trigger operation and may detect the target pad corresponding to the state of the electronic device 200 among the plurality of position pads 281. As an example, when a trigger operation for changing the electronic device 200 to the second state S2 is sensed in operation 310, the processor 120 may detect the second pad set 281b as the target pad. In another example, when a trigger operation for changing the electronic device 200 to the fourth state S4 is sensed in operation 310, the processor 120 may detect the fourth pad set 281d as the target pad.

In operation 330, the processor 120 may move the second housing 230 by driving the motor 296. The processor 120 may move the second housing 230 relative to the first housing 210 in the first direction D1 or the second direction D2 by controlling the motor 296 such that the conductive member 270 is brought into contact with the target pad. In operation 330 of driving the motor and moving the second housing, the conductive member 270 may move toward the target pad, and the display 250 may be extended or reduced in response to the direction of movement of the second housing 230.

In operation 340, the processor 120 may detect whether the conductive member 270 is in contact with the target pad. The processor 120 may, for example, determine whether the conductive member 270 is in contact with one pad set designated as the target pad among the plurality of position pads 280. The processor 120 may determine contact of the conductive member 270 through signals (e.g., refer to FIG. 16) of the plurality of position pads 281, and when contact with the target pad is sensed, the processor 120 may determine that the change of state of the electronic device 200 is completed.

In operation 350, the processor 120 may stop the motor when recognizing that the change of state of the electronic device 200 is completed. For example, when the motor is stopped, the electronic device 200 may be maintained in a specific state, in which the change of state is completed, by a back-drive state (e.g., a back-drive force) of the motor.

According to various embodiments, in operation 310 of sensing the trigger operation, the electronic device 200 may sense an operation in which an external force having a certain magnitude is applied to the electronic device 200, as the trigger operation. As an example, when a certain external force is applied to the second housing 230 in the second direction D2 or an external force caused by impact is applied to the electronic device 200 in the second state S2 of the electronic device 200, the processor 120 may sense the application of the external force as the trigger operation and may change the electronic device 200 to the first state S1. When a certain external force is applied to the second housing 230 in the first direction D1 in the first state S1 of the electronic device 200, the processor 120 may sense the application of the external force as the trigger operation and may change the electronic device 200 to the second state S2. Here, the magnitude of the applied external force may be greater than the magnitude of the back-drive force of the motor.

In other embodiments, when an external force applied to the electronic device 200 or the second housing 230 is sensed as the trigger operation in the second state S2 of the electronic device 200, the processor 120 may detect, through a combination with an acceleration sensor, a situation in which the electronic device 200 drops and may change the electronic device 200 to the first state S1. For example, when the electronic device 200 is dropped in the second state S2, the electronic device 200 may determine the falling situation when the second housing 230 is slightly closed due to drop impact and may change the electronic device 200 to the first state S1, based on the fact that the position of the conductive member 270 is changed. Damage to the drive member (e.g., the drive member 293 of FIG. 8) may be prevented.

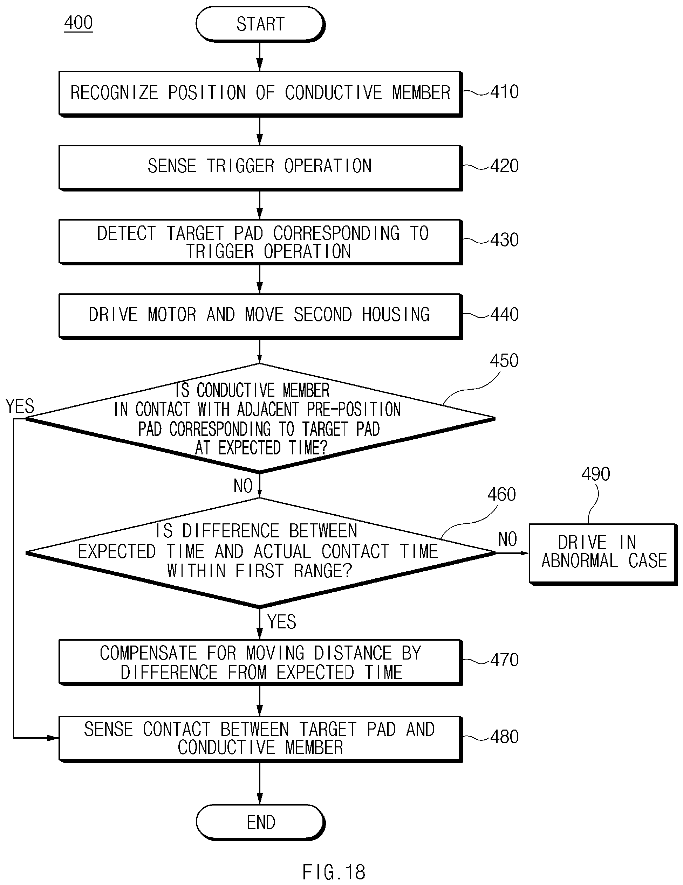

FIG. 18 is a flowchart illustrating an operating method of an electronic device according to an embodiment of the disclosure.

Hereinafter, in describing FIG. 18, operations of an electronic device may be understood as operations of the control circuit (e.g., a processor 120 of FIG. 1), and the following description will be made with reference to FIG. 18 together with FIGS. 14 and 15.

Referring to FIG. 18, the operating method 400 of the electronic device according to an embodiment may include operation 410 of recognizing the position of the conductive member, operation 420 of sensing a trigger operation, operation 430 of detecting a target pad corresponding to the trigger operation, operation 440 of driving the motor and moving the second housing, operation 450 of determining whether the conductive member is in contact with the pre-position pad adjacent to the target pad at calculated expected time, operation 460 of determining whether a difference from the expected time is within a first range, operation 470 of compensating for a moving distance by the difference from the expected time, operation 480 of sensing contact between the target pad and the conductive member, and operation 490 of driving the electronic device in an abnormal case.

In the operating method 400 of the electronic device 200, according to an embodiment, operation 420, operation 430, operation 440, and operation 480 may be the same as the operations (e.g., operation 310, operation 320, operation 330, and operation 340) included in the operating method 300 of FIG. 17.

In operation 410, the processor 120 may recognize the current position of the conductive member 270. In an example, the electronic device 200 may be in one of the first to fourth states S1 to S4, and the conductive member 270 may be placed at a position brought into contact with one of the plurality of position pads 281 in response to the state of the electronic device 200.

In operation 420, the processor 120 may sense the trigger operation for changing the electronic device 200 to one of the first to fourth states S1 to S4.

In operation 430, the processor 120 may detect the target pad corresponding to the state to which the electronic device 200 is to be changed by the trigger operation, among the plurality of position pads 281.

In operation 440, the processor 120 may drive the motor 296 and may move the second housing 230 such that the conductive member 270 moves toward the target pad. In operation 440, based on the driving speed of the motor 296 and the moving distance of the conductive member 270 (e.g., the distance between the current position of the conductive member 270 and the target pad), the processor 120 may calculate and determine the expected time it takes the conductive member 270 to move to the target pad or the expected time it takes the conductive member 270 to move to the pre-position pad 282 adjacent to the target pad. The pre-position pad 282 adjacent to the target pad may, for example, refer to the pre-position pad 282 spaced apart from one position pad 281 designated as the target pad by the first distance L in the direction opposite to the direction of movement of the conductive member 270. For another example, when in operation 410, the conductive member 270 is recognized as being located on the first pad set 281a (the first state S1) and the trigger operation for changing the electronic device 200 to the fourth state S4 is sensed in operation 420, the processor 120 may, in operation 440, calculate and determine the expected time it takes the conductive member 270 to make contact with the fourth pad set 281d and the expected time it takes the conductive member 270 to make contact with the fourth pre-pad set 282c adjacent to the fourth pad set 281d on the moving path of the conductive member 270.

In operation 450, the processor 120 may determine whether the conductive member 270 is in contact with the pre-position pad 282 adjacent to the target pad at the expected time. When it is determined that the conductive member 270 is in contact with the pre-position pad 282 adjacent to the target pad at the expected time, the processor 120 may perform operation 480, and when it is determined that the conductive member 270 is not in contact with the pre-position pad 282 adjacent to the target pad at the expected time, the processor 120 may perform operation 460.

When it is determined that the conductive member 270 is in contact with the pre-position pad 282 at the expected time (e.g., operation 450 - YES), the processor 120 may sense contact between the conductive member 270 and the target pad in operation 480 and may stop the motor (e.g., operation 350 of FIG. 17).

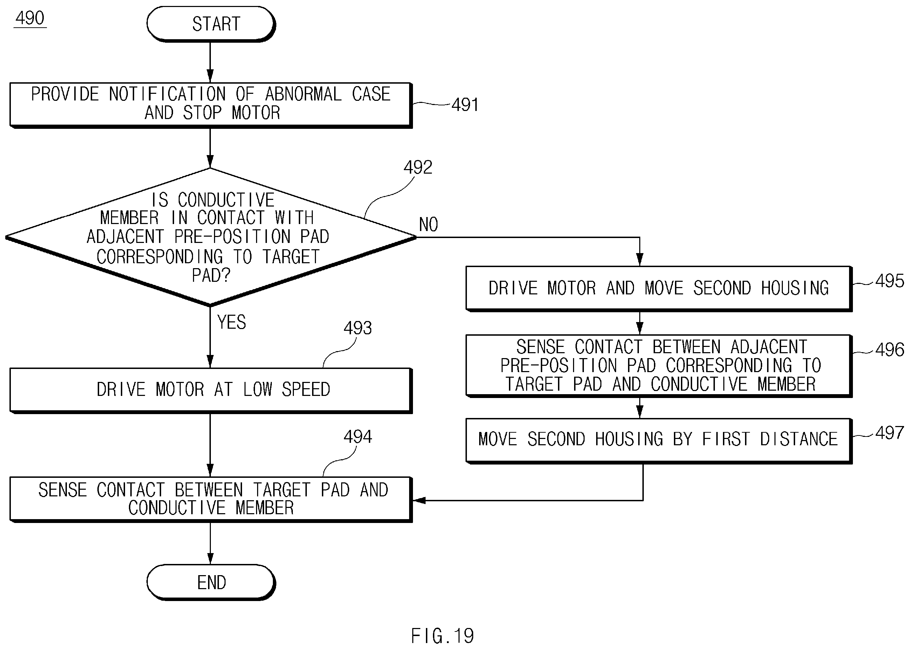

When it is determined that the conductive member 270 is not in contact with the pre-position pad 282 at the expected time, the processor 120 may, in operation 460, determine whether a difference from the expected time is within a first range. The processor 120 may determine whether the difference between the time when the conductive member 270 is in contact with the pre-position pad 282 and the expected time is within the first range. When the difference is within the first range, the processor 120 may perform operation 470, and when the difference is not within the first range, the processor 120 may determine the abnormal case and may perform operation 490 (e.g., refer to FIG. 19).

When the difference from the expected time is within the first range (e.g., operation 460 - YES), the processor 120 may, in operation 470, compensate for the moving distance by the difference between the expected time and the actual contact time. When the actual contact time is slower than the expected time by a first time period, an error may occur as much as the distance the conductive member 270 moves due to the driving of the motor 296 for the first time period. The processor 120 may compensate for the moving distance of the conductive member 270 by additionally operating the motor for the first time period.

In operation 480, the processor 120 may sense the contact between the conductive member 270 and the target pad and may stop the motor (e.g., operation 350 of FIG. 17).

According to other embodiments, in the electronic device 200, the motor 296 may be implemented with a step motor having a specified step speed (e.g., PPS), and the distance the conductive member 270 moves per 1 step may be defined depending on the characteristics of the drive member 293. Based on the step speed of the motor, the moving distance of the conductive member 270 per 1 step, and the distance between the sensing pads 280, the processor 120 may determine the expected time it takes the conductive member 270 to make contact with the sensing pads 280. However, without being limited to the step motor, the motor 296 may be implemented with various types of motors.

FIG. 19 is a flowchart illustrating an operating method of an electronic device according to an embodiment of the disclosure.

FIG. 19 is a flowchart illustrating operation 490 in which an electronic device 200 is driven in the abnormal case. Hereinafter, in describing FIG. 19, operations of the electronic device may be understood as operations of the control circuit (e.g., a processor 120 of FIG. 1), and the following description will be made with reference to FIG. 19 together with FIGS. 14 and 15.

Referring to FIG. 19, when the difference between the actual contact time and the expected contact time of the conductive member 270 and the pre-position pad 282 exceeds the first range in the operating method of FIG. 18 (e.g., operation 460 - NO in FIG. 18), the electronic device 200 may perform operation 490 in which the electronic device 200 is driven in the abnormal case.

In operation 491, the processor 120 may determine the abnormal case, may display a notification of the abnormal case, and may stop the motor.

In operation 492, the processor 120 may determine whether the conductive member 270 is in contact with the pre-position pad 282 adjacent to the target pad. When the conductive member 270 has already made contact with the adjacent pre-position pad 282 or is in contact with the adjacent pre-position pad 282, the processor 120 may perform operation 493, and when the conductive member 270 is not yet in contact with the adjacent pre-position pad 282, the processor 120 may perform operation 495.

When the conductive member 270 is in contact with the pre-position pad 282 adjacent to the target pad (e.g., operation 492 - YES), the processor 120 may, in operation 493, slowly move the second housing 230 and the conductive member 270 by driving the motor 296 at low speed. In operation 494, the processor 120 may sense the contact between the conductive member 270 and the target pad and may stop the motor (e.g., operation 350 of FIG. 17).

When the conductive member 270 is not in contact with the pre-position pad 282 adjacent to the target pad (e.g., operation 492 - NO), the processor 120 may, in operation 495, drive the motor again and move the second housing 230 such that the conductive member 270 moves toward the target pad (e.g., operation 440 of FIG. 18). For example, the processor 120 may drive the motor 296 until the conductive member 270 makes contact with the adjacent pre-position pad 282 corresponding to the target pad.

In operation 496, the processor 120 may sense the contact between the adjacent pre-position pad 282 corresponding to the target pad and the conductive member 270. When in the operating method 400 of FIG. 18, the conductive member 270 is recognized in the state of being located on the second pad set 281b (e.g., operation 410) and the target pad is designated as the fourth pad set 281d (e.g., operation 430), the processor 120 may sense that the conductive member 270 is brought into contact with the fifth pre-pad set 282d spaced apart from the fourth pad set 281d by the first distance L in the direction toward the second pad set 281b.

In operation 497, the processor 120 may move the second housing 230 by the first distance L. For example, the processor 120 may locate the conductive member 270 on the target pad by driving the motor 296 to move the conductive member by the first distance L. The first distance L may be the same as the distance between the target pad and the adjacent pre-position pad 282 corresponding to the target pad. For another example, the processor 120 may bring the conductive member 270 into contact with the target pad by moving the conductive member 270 by the first distance L, based on when the processor 120 senses the contact between the adjacent pre-position pad 282 and the conductive member 270. When the contact between the conductive member 270 and the target pad is sensed, the processor 120 may stop the motor 296 (operation 494).

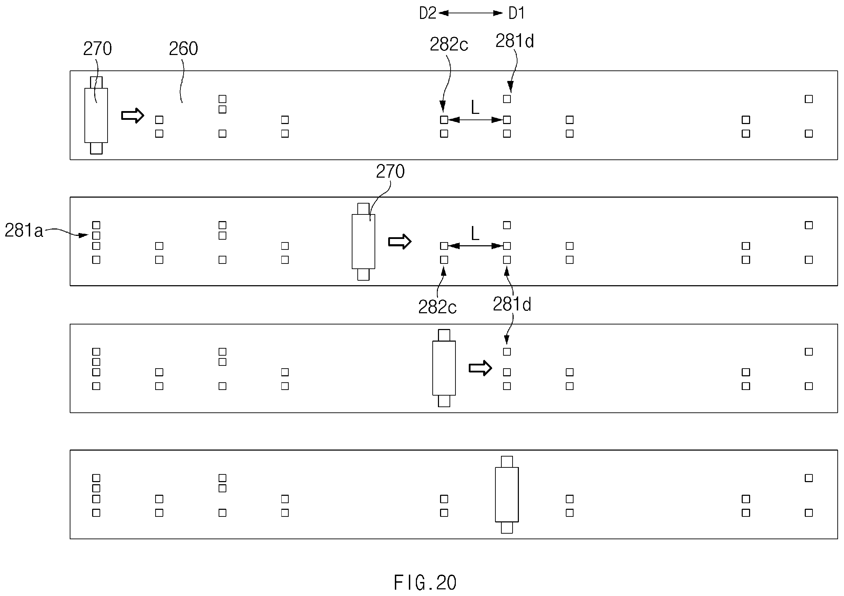

FIG. 20 is a view illustrating an operation in which a conductive member moves in response to a change of state of an electronic device according to an embodiment of the disclosure.

An example of driving the electronic device in the abnormal case (operation 490) in the operating method 400 of the electronic device 200 will be described with reference to FIG. 20 together with the flowcharts of FIGS. 18 and 19.

Referring to FIGS. 18, 19, and 20, an operation for changing the electronic device 200 from the first state (e.g., the first state S1 of FIG. 15) to the fourth state (e.g., the fourth state S4 of FIG. 15) may be performed. For example, FIG. 20 may be a view illustrating a process in which the conductive member 270 moves when the operation method 400 in which the electronic device 200 is changed from the first state to the fourth state is performed. When the electronic device 200 is changed from the first state to the fourth state, the conductive member 270 may move on the sensing substrate 260 in the first direction D1.

In operation 410, the processor 120 may recognize that the conductive member 270 is in contact with the first pad set 281a and may determine that the electronic device 200 is in the first state.

In operation 420, a trigger operation for changing the electronic device 200 to the fourth state may be input by a user and/or an external factor, and the processor 120 may sense the trigger operation.

In operation 430, in response to the trigger operation for changing the electronic device 200 to the fourth state, the processor 120 may, for example, detect the fourth pad set 281d corresponding to the fourth state as a target pad.

In operation 440, the processor 120 may drive the motor such that the conductive member 270 makes contact with the fourth pad set 281d and may move the second housing 230 and the conductive member 270 in the first direction D1.

In operation 450, the processor 120 may recognize the fourth pre-pad set 282c spaced apart from the fourth pad set 281d in the second direction D2 as an adjacent pre-position pad corresponding to the target pad and may, for example, determine whether the conductive member 270 is in contact with the fourth pre-pad set 282c at calculated expected time.

In operation 460, when it is determined that the conductive member 270 is not in contact with the fourth pre-pad set 282c at the expected time, the processor 120 may determine whether a difference from the expected time is within a specified first range and may drive the electronic device in an abnormal case (operation 490) when the difference exceeds the first range.

In operation 491, the processor 120 may display a notification of the abnormal case and may stop the conductive member by stopping the motor.

In operation 492, the processor 120 may, for example, determine whether the conductive member 270 is in contact with the fourth pre-pad set 282c or whether the conductive member 270 passes the fourth pre-pad set 282c after making contact with the fourth pre-pad set 282c.

In operations 493 and 494, when it is determined that the conductive member 270 is in contact with the fourth pre-pad set 282c or passes the fourth pre-pad set 282c after making contact with the fourth pre-pad set 282c, the processor 120 may, for example, drive the motor at low speed until the conductive member 270 makes contact with the fourth pad set 281d.

In operation 495, when it is determined that the conductive member 270 is not yet in contact with the fourth pre-pad set 282c, the processor 120 may move the second housing 230 and the conductive member 270 in the first direction D1 by driving the motor until the conductive member 270 makes contact with the fourth pre-pad set 282c.

In operations 496 and 497, the processor 120 may, for example, sense contact between the conductive member 270 and the fourth pre-pad set 282c, and based on this time point, the processor 120 may drive the motor such that the second housing 230 and the conductive member 270 move in the first direction D1 by the first distance L. For example, the first distance L may be substantially the same as the distance between the fourth pad set 281d, which is the target pad, and the fourth pre-pad set 282c, which is the adjacent pre-position pad.

By recognizing the operation in which the conductive member 270 makes contact with one of the plurality of position pads 281 and the plurality of pre-position pads 282 depending on the extension or reduction of the display 250, the electronic device 200 according to various embodiments of the disclosure may accurately determine the current state of the electronic device 200 (or, the degree of extension of the display 250) and may precisely control the operation in which the state of the electronic device 200 is changed.

An electronic device 200 according to an embodiment of the disclosure may include a first housing 210, a second housing 230 coupled to the first housing so as to slide in a first direction D1 and a second direction D2 opposite to the first direction, a flexible display 250 including an exposed region that is exposed on a front surface of the electronic device and varied in size in response to sliding of the second housing, a sensing substrate 260 disposed in the first housing, and a conductive roller 270 (i.e. conductive member 270) disposed in the second housing so as to be rotatable. A plurality of sensing pads 280 may be disposed on one surface of the sensing substrate. The conductive roller may be configured to make contact with a part of the plurality of sensing pads as the second housing slides relative to the first housing. The plurality of sensing pads may include a plurality of position pads 281 that make contact with the conductive roller in a state in which the exposed region of the flexible display is formed in one or more specified sizes.

In various embodiments, the conductive roller may move relative to the sensing substrate as the second housing slides relative to the first housing. The electronic device may be changed to a plurality of states S1, S2, S3, and S4 in which the exposed region of the flexible display has different sizes, based on the sliding of the second housing. The plurality of states of the electronic device may, for example, include a first state S1 in which the exposed region has a first size W1, a second state S2 in which the exposed region has a second size W2 greater than the first size, and a third state S3 in which the exposed region has a third size W3 greater than the first size and smaller than the second size. The plurality of position pads may include a first pad set 281a brought into contact with the conductive roller in the first state, a second pad set 281b brought into contact with the conductive roller in the second state, and a third pad set 281c brought into contact with the conductive roller in the third state.

In various embodiments, the first pad set, the second pad set, and the third pad set may be sequentially arranged on the one surface of the sensing substrate in the first direction.

In other embodiments, the plurality of states of the electronic device may further include a fourth state S4 in which the exposed region has a fourth size W4 greater than the third size and smaller than the second size, and the plurality of position pads may further include a fourth pad set 281d brought into contact with the conductive roller in the fourth state and disposed between the third pad set and the second pad set.

In still other embodiments, the sensing pads may further include a plurality of pre-position pads 282d disposed between the plurality of position pads located adjacent to each other, and the plurality of pre-position pads may be spaced apart from the plurality of position pads by a specified distance L.

In various embodiments, the plurality of pre-position pads may include a first pre-pad set 282a disposed at a position spaced apart from the first pad set by a first distance L in the first direction, a second pre-pad set 282e disposed at a position spaced apart from the second pad set by the first distance in the second direction, and a third pre-pad set 282b disposed at a position spaced apart from the third pad set by the first distance in the first direction.

In other embodiments, the first pre-pad set may be disposed at a position spaced apart from the third pad set by the first distance in the second direction.

In various embodiments, the first housing may include a fixed cover 211 that forms at least a portion of side and rear surfaces of the electronic device and a first support member 220 coupled to the fixed cover, and the sensing substrate may be disposed on the first support member.

In still other embodiments, the sensing substrate may include a first surface 261 coupled to the first support member and a second surface 263 that faces away from the first surface and on which the sensing pads are disposed. The sensing substrate may be disposed such that the first surface and the second surface are perpendicular to the front surface or the rear surface of the electronic device.

In various embodiments, the second housing may include a sliding cover 231 disposed in an inner space of the fixed cover so as to slide and a second support member 240 coupled to the sliding cover so as to integrally move with the sliding cover, and the conductive roller may be disposed on the second support member.

In other embodiments, the conductive roller may be coupled to the second support member so as to be rotatable about a rotational axis R, and the rotational axis may extend in a direction perpendicular to the first direction and the second direction.

In still other embodiments, the plurality of sensing pads may protrude from the one surface of the sensing substrate by a certain height.

In various embodiments, the electronic device may further include a processor 120 operatively connected with the position pads, and the processor may be configured to sense contact between the conductive roller and the position pads and determine a position of the conductive roller based on a signal recognized by the contact and a change in the signal.

The electronic device may further include a drive member 293 that moves the second housing relative to the first housing. The drive member may include a motor 296 operatively connected with the processor. The processor may be configured to sense a trigger operation for changing a state of the electronic device, detect a part of the position pads as a target pad in response to the sensed trigger operation, move the second housing by driving the motor such that the conductive roller is brought into contact with the target pad, and sense contact between the conductive roller and the target pad.

In embodiments, the sensing pads may further include a plurality of pre-position pads 282 disposed at positions spaced apart from the plurality of position pads by a first distance in at least one of the first direction or the second direction. The plurality of pre-position pads may be operatively connected with the processor. The processor may be configured to compare expected time it takes the conductive roller to make contact with an adjacent pre-position pad corresponding to the target pad and contact time spent in actual contact, compensate for a moving distance by the difference by controlling driving of the motor when a difference between the expected time and the contact time is within a first range, and drive in an abnormal case when the difference between the expected time and the contact time exceeds the first range.

In other embodiments, when driving in the abnormal case, the processor may be configured to sense whether the conductive roller makes contact with the adjacent pre-position pad, drive the motor such that the conductive roller is brought into contact with the adjacent pre-position pad, when contact between the conductive roller and the adjacent pre-position pad is not sensed, and move the conductive roller by the first distance, based on when contact between the conductive roller and the adjacent pre-position pad is sensed.

In still other embodiments, the motor may be implemented with a step motor, and the processor may be configured to determine expected time it takes the conductive roller to make contact with the target pad or the adjacent pre-position pad, based on a step speed of the motor, a moving distance of the conductive roller per 1 step, and a distance between the sensing pads.

In various embodiments, the adjacent pre-position pad corresponding to the target pad may be defined as the plurality of pre-position pads disposed at positions spaced apart from the target pad by the first distance in a direction opposite to a direction in which the conductive roller moves toward the target pad.

The conductive roller may include an elastic material.

In various embodiments, the plurality of position pads may further include a fourth pad set 281d corresponding to a fourth state S4 defined as a state between the third state and the second state, and the plurality of pre-position pads may further include a fourth pre-pad set 282c disposed at a position spaced apart from the fourth pad set by the first distance in the second direction and a fifth pre-pad set 282d disposed at a position spaced apart from the fourth pad set by the first distance in the first direction.

In various embodiments, one or more non-transitory computer-readable storage media storing one or more computer programs including computer-executable instructions that, when executed by one or more processors of an electronic device, cause the electronic device to perform operations, the operations comprising: sensing contact between a conductive roller and a plurality of position pads; determining a position of the conductive roller based on a signal recognized by a contact and a change in a signal; comparing expected time it takes the conductive roller to make contact with an adjacent pre-position pad corresponding to a target pad and contact time spent in actual contact; compensating for a moving distance by difference by controlling driving of a motor when a difference between the expected time and the contact time is within a first range; and driving in an abnormal case when the difference between the expected time and the contact time exceeds the first range.

In various embodiments, when driving in the abnormal case, the operations further comprising: sensing whether the conductive roller makes contact with the adjacent pre-position pad, driving the motor such that the conductive roller is brought into contact with the adjacent pre-position pad, when contact between the conductive roller and the adjacent pre-position pad is not sensed, and moving the conductive roller by a first distance, based on when contact between the conductive roller and the adjacent pre-position pad is sensed.

An electronic device 200, according to one embodiment of the disclosure, may include a first housing 210, a second housing 230 coupled to the first housing so as to slide in a first direction D1 and a second direction D2 opposite to the first direction, a display 250, at least a portion of which is disposed in the first housing, the display 250 including an exposed region that is exposed on a front surface of the electronic device and varied in size in response to sliding of the second housing, a sensing substrate 260 that is disposed in one of the first housing and the second housing and that has sensing pads 280 disposed on one surface thereof, and a conductive roller 270 that is disposed in the other one of the first housing and the second housing to face the sensing substrate and that moves relative to the sensing substrate as the second housing slides relative to the first housing. The electronic device may be, for example, changed to a plurality of states S1, S2, S3, and S4 in which the exposed region has different sizes, based on the sliding of the second housing. The sensing pads may include a plurality of position pads 281 brought into contact with the conductive roller in response to the plurality of states of the electronic device.

The electronic device, according to various embodiments, may be one of various types of electronic devices. The electronic devices may include, for example, a portable communication device (e.g., a smartphone), a computer device, a portable multimedia device, a portable medical device, a camera, a wearable device, or a home appliance. According to an embodiment, the electronic devices are not limited to those described above.

It should be appreciated that embodiments of the disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1^{st}" and "2^{nd}," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software (e.g., the program 140) including one or more instructions that are stored in a storage medium (e.g., internal memory 136 or external memory 138) that is readable by a machine (e.g., the electronic device 101). In an example, a processor(e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

A method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities and some of multiple entities may be separately disposed on the other components. According to other embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to still other embodiments, operations performed by the module, the program, or another component may be carried out sequentially, in parallel, repeatedly, or heuristically, or one or more of the operations may be executed in a different order or omitted, or one or more other operations may be added.

Any such software may be stored in non-transitory computer readable storage media. The non-transitory computer readable storage media store one or more computer programs (software modules), the one or more computer programs include computer-executable instructions that, when executed by one or more processors of an electronic device, cause the electronic device to perform a method of the disclosure.

Any such software may be stored in the form of volatile or non-volatile storage such as, for example, a storage device like read only memory (ROM), whether erasable or rewritable or not, or in the form of memory such as, for example, random access memory (RAM), memory chips, device or integrated circuits or on an optically or magnetically readable medium. It will be appreciated that the storage devices and storage media are various embodiments of non-transitory machine-readable storage that are suitable for storing a computer program or computer programs comprising instructions that, when executed, implement various embodiments of the disclosure. Accordingly, various embodiments provide a program comprising code for implementing apparatus or a method as claimed in any one of the claims of this specification and a non-transitory machine-readable storage storing such a program.

While the disclosure has been shown and described with reference to various embodiments thereof, it will be understood by those skilled in the art that various changes in form and details may be made therein without departing from the scope of the disclosure as defined by the appended claims.

## Claims

1. An electronic device (101, 200) comprising:
a first housing (210);
a second housing (230) coupled to the first housing (210) so as to slide in a first direction (D1) and a second direction (D2) opposite to the first direction (D1);
a flexible display (250) including an exposed region exposed on a front surface of the electronic device (101, 200), the exposed region being varied in size in response to sliding of the second housing (230);
a sensing substrate (260) disposed in the first housing (210); and
a conductive roller (270) disposed in the second housing (230) so as to be rotatable,
wherein a plurality of sensing pads (280) are disposed on one surface of the sensing substrate (260) and are disposed at positions corresponding to a plurality of states of the electronic device,
wherein the conductive roller (270) is configured to move relative to the sensing substrate (260) as the second housing (230) slides relative to the first housing (210),
wherein the conductive roller (270) is configured to make direct contact with a part of the plurality of sensing pads (280) while moving on the sensing substrate (260) and cause a change in voltage connected to the contacted sensing pads (280).

2. The electronic device (101, 200) of claim 1,
wherein the electronic device (101, 200) is changed to the plurality of states in which the exposed region of the flexible display (250) has different sizes, based on the sliding of the second housing (230),
wherein the plurality of states of the electronic device (101, 200) include:
a first state (S1) in which the exposed region has a first size,
a second state (S2) in which the exposed region has a second size greater than the first size, and
a third state (S3) in which the exposed region has a third size greater than the first size and smaller than the second size,
wherein the plurality of sensing pads (280) include a plurality of position pads (281) configured to make contact with the conductive roller (270) in a state in which the exposed region of the flexible display (250) is formed in one or more specified sizes, and
wherein the plurality of position pads (281) include:
a first pad set (281a) brought into contact with the conductive roller (270) in the first state (S1),
a second pad set (281b) brought into contact with the conductive roller (270) in the second state (S2), and
a third pad set (281c) brought into contact with the conductive roller (270) in the third state (S3).

3. The electronic device (101, 200) of claim 2, wherein the first pad set (281a), the second pad set (281b), and the third pad set (281c) are sequentially arranged on the one surface of the sensing substrate (260) in the first direction (D1).

4. The electronic device (101, 200) of claim 3,
wherein the plurality of states of the electronic device (101, 200) further include a fourth state (S4) in which the exposed region has a fourth size greater than the third size and smaller than the second size, and
wherein the plurality of position pads (281) further include a fourth pad set (281d) brought into contact with the conductive roller (270) in the fourth state (S4) and disposed between the third pad set (281c) and the second pad set (281b).

5. The electronic device (101, 200) of claim 2,
wherein the sensing pads (280) further include one or more pre-position pads (282) disposed between the plurality of position pads (281) located adjacent to each other, and
wherein the one or more pre-position pads (282) are spaced apart from the plurality of position pads (281) by a specified distance.

6. The electronic device (101, 200) of claim 5, wherein the one or more pre-position pads (282) include:
a first pre-pad set (282a) disposed at a position spaced apart from the first pad set (281a) by a first distance in the first direction (D1);
a second pre-pad set (282e) disposed at a position spaced apart from the second pad set (281b) by the first distance in the second direction (D2); and
a third pre-pad set (282b) disposed at a position spaced apart from the third pad set (281c) by the first distance in the first direction (D1).

7. The electronic device (101, 200) of claim 6, wherein the first pre-pad set (282a) is disposed at a position spaced apart from the third pad set (281c) by the first distance in the second direction (D2).

8. The electronic device (101, 200) of claim 1,
wherein the first housing (210) includes a fixed cover (211) configured to form at least a portion of side and rear surfaces of the electronic device (101, 200) and a first support member (220) coupled to the fixed cover (211), and
wherein the sensing substrate (260) is disposed on the first support member (220).

9. The electronic device (101, 200) of claim 8,
wherein the sensing substrate (260) includes a first surface (261) coupled to the first support member (220) and a second surface (263) on which the sensing pads (280) are disposed, the second surface (263) being configured to face away from the first surface (261), and
wherein the sensing substrate (260) is disposed such that the first surface (261) and the second surface (263) are perpendicular to the front surface or the rear surface of the electronic device (101, 200).

10. The electronic device (101, 200) of claim 8,
wherein the second housing (230) includes a sliding cover (231) disposed in an inner space of the fixed cover (211) so as to slide and a second support member (240) coupled to the sliding cover (231) so as to integrally move with the sliding cover (231), and
wherein the conductive roller (270) is disposed on the second support member (240).

11. The electronic device (101, 200) of claim 10,
wherein the conductive roller (270) is coupled to the second support member (240) so as to be rotatable about a rotational axis, and
wherein the rotational axis extends in a direction perpendicular to the first direction (D1) and the second direction (D2).

12. The electronic device (101, 200) of claim 1, further comprising:
one or more processors (120) operatively connected with a plurality of position pads (281) including the plurality of sensing pads (280),
memory (130) storing one or more computer programs (140) including computer-executable instructions that, when executed by the one or more processors (120), cause the electronic device (101, 200) to:
sense contact between the conductive roller (270) and the plurality of position pads (281), and
determine a position of the conductive roller (270) based on the voltage recognized by the contact and a change in the voltage.

13. The electronic device (101, 200) of claim 12, further comprising:
a drive member (293) configured to move the second housing (230) relative to the first housing (210),
wherein the drive member (293) includes a motor (296) operatively connected with the processor (120), and
wherein the one or more computer programs (140) further comprise computer-executable instructions to:
sense (310) a trigger operation for changing a state of the electronic device (101, 200),
detect (320) a part of the plurality of position pads (281) as a target pad (280) in response to the sensed trigger operation,
move (330) the second housing (230) by driving the motor (296) such that the conductive roller (270) is brought into contact with the target pad (280), and
sense (340) contact between the conductive roller (270) and the target pad (280).

14. The electronic device (101, 200) of claim 13,
wherein the sensing pads (280) further include a one or more pre-position pads (282) disposed at positions spaced apart from the plurality of position pads (281) by a first distance in at least one of the first direction (D1) or the second direction (D2),
wherein the one or more pre-position pads (282) are operatively connected with the processor (120), and
wherein the one or more computer programs (140) further comprise computer-executable instructions to:
compare (450) expected time it takes the conductive roller (270) to make contact with an adjacent pre-position pad (282) corresponding to the target pad (280) and contact time spent in actual contact,
compensate (470) for a moving distance by difference by controlling driving of the motor (296) when (460) a difference between the expected time and the contact time is within a first range, and
drive (490) in an abnormal case when the difference between the expected time and the contact time exceeds the first range.

15. The electronic device (101, 200) of claim 14, wherein, when driving (490) in the abnormal case, the one or more computer programs (140) further comprise computer-executable instructions to:
sense (492) whether the conductive roller (270) makes contact with the adjacent pre-position pad (282),
drive (495) the motor (296) such that the conductive roller (270) is brought into contact with the adjacent pre-position pad (282), when contact between the conductive roller (270) and the adjacent pre-position pad (282) is not sensed, and
move (497) the conductive roller (270) by the first distance, based on when contact between the conductive roller (270) and the adjacent pre-position pad (282) is sensed (496).

## Patentansprüche

1. Elektronische Vorrichtung (101, 200), umfassend:
ein erstes Gehäuse (210);
ein zweites Gehäuse (230), das mit dem ersten Gehäuse (210) gekoppelt ist, um in einer ersten Richtung (D1) und einer zweiten Richtung (D2) entgegengesetzt zur ersten Richtung (D1) zu gleiten;
eine flexible Anzeige (250), die einen freiliegenden Bereich umfasst, der auf einer Vorderseite der elektronischen Vorrichtung (101, 200) freiliegt, wobei die Größe des freiliegenden Bereichs als Reaktion auf das Gleiten des zweiten Gehäuses (230) variiert wird;
ein Sensorsubstrat (260), das in dem ersten Gehäuse (210) angeordnet ist; und
eine leitfähige Walze (270), die in dem zweiten Gehäuse (230) drehbar angeordnet ist,
wobei eine Vielzahl von Erfassungspolstern (280) auf einer Fläche des Sensorsubstrats (260) angeordnet sind und an Positionen angeordnet sind, die einer Vielzahl von Zuständen der elektronischen Vorrichtung entsprechen,
wobei die leitfähige Walze (270) konfiguriert ist, um sich relativ zu dem Sensorsubstrat (260) zu bewegen, wenn das zweite Gehäuse (230) relativ zum ersten Gehäuse (210) gleitet,
wobei die leitfähige Walze (270) konfiguriert ist, um direkten Kontakt mit einem Teil der Vielzahl von Erfassungspolstern (280) herzustellen, während sie sich auf dem Sensorsubstrat (260) bewegt und eine Änderung in der Spannung verursacht, die mit den kontaktierten Erfassungspolstern (280) verbunden ist.

2. Elektronische Vorrichtung (101, 200) nach Anspruch 1,
wobei die elektronische Vorrichtung (101, 200) basierend auf dem Gleiten des zweiten Gehäuses (230) in die Vielzahl von Zuständen geändert wird, in denen der freiliegende Bereich der flexiblen Anzeige (250) unterschiedliche Größen aufweist,
wobei die Vielzahl von Zuständen der elektronischen Vorrichtung (101, 200) Folgendes umfasst:
einen ersten Zustand (S1), in dem der freiliegende Bereich eine erste Größe aufweist,
einen zweiten Zustand (S2), in dem der freiliegende Bereich eine zweite Größe aufweist, die größer ist als die erste Größe, und
einen dritten Zustand (S3), in dem der freiliegende Bereich eine dritte Größe aufweist, die größer als die erste Größe und kleiner als die zweite Größe ist,
wobei die Vielzahl von Erfassungspolstern (280) eine Vielzahl von Positionspolstern (281) umfasst, die so konfiguriert sind, dass sie in einem Zustand, in dem der freiliegende Bereich der flexiblen Anzeige (250) in einer oder mehreren spezifizierten Größen ausgebildet ist, mit der leitfähigen Walze (270) in Kontakt kommen, und
wobei die Vielzahl von Positionspolstern (281) Folgendes umfasst:
einen ersten Polstersatz (281a), der im ersten Zustand (S1) mit der leitfähigen Walze (270) in Kontakt gebracht wird,
einen zweiten Polstersatz (281b), der im zweiten Zustand (S2) mit der leitfähigen Walze (270) in Kontakt gebracht wird, und
einen dritten Polstersatz (281c), der im dritten Zustand (S3) mit der leitfähigen Walze (270) in Kontakt gebracht wird.

3. Elektronische Vorrichtung (101, 200) nach Anspruch 2, wobei der erste Polstersatz (281a), der zweite Polstersatz (281b) und der dritte Polstersatz (281c) nacheinander auf der einen Fläche des Sensorsubstrats (260) in der ersten Richtung (D1) angeordnet sind.

4. Elektronische Vorrichtung (101, 200) nach Anspruch 3,
wobei die Vielzahl von Zuständen der elektronischen Vorrichtung (101, 200) ferner einen vierten Zustand (S4) beinhaltet, in dem der freiliegende Bereich eine vierte Größe aufweist, die größer als die dritte Größe und kleiner als die zweite Größe ist, und
wobei die Vielzahl von Positionspolstern (281) ferner einen vierten Polstersatz (281d) beinhaltet, der im vierten Zustand (S4) in Kontakt mit der leitfähigen Walze (270) gebracht wird und zwischen dem dritten Polstersatz (281c) und dem zweiten Polstersatz (281b) angeordnet ist.

5. Elektronische Vorrichtung (101, 200) nach Anspruch 2,
wobei die Erfassungspolster (280) ferner ein oder mehrere Vorpositionierungspolster (282) beinhalten, die zwischen der Vielzahl von Positionspolstern (281) angeordnet sind, die einander benachbart sind, und
wobei das eine oder die mehreren Vorpositionierungspolster (282) von der Vielzahl von Positionspolstern (281) um einen bestimmten Abstand beabstandet sind.

6. Elektronische Vorrichtung (101, 200) nach Anspruch 5, wobei das eine oder die mehreren Vorpositionierungspolster (282) Folgendes umfassen:
einen ersten Vorpolstersatz (282a), der an einer Position positioniert ist, die vom ersten Polstersatz (281a) um einen ersten Abstand in der ersten Richtung (D1) beabstandet ist;
einen zweiten Vorpolstersatz (282e), der an einer Position positioniert ist, die vom zweiten Polstersatz (281b) um den ersten Abstand in der zweiten Richtung (D2) beabstandet ist; und
einen dritten Vorpolstersatz (282b), der an einer Position positioniert ist, die vom dritten Polstersatz (281c) um den ersten Abstand in der ersten Richtung (D1) beabstandet ist.

7. Elektronische Vorrichtung (101, 200) nach Anspruch 6, wobei der erste Vorpolstersatz (282a) an einer Position angeordnet ist, die vom dritten Polstersatz (281c) um den ersten Abstand in der zweiten Richtung (D2) beabstandet ist.

8. Elektronische Vorrichtung (101, 200) nach Anspruch 1,
wobei das erste Gehäuse (210) eine feste Abdeckung (211) umfasst, die so konfiguriert ist, dass sie mindestens einen Abschnitt der Seiten- und Rückseitenflächen der elektronischen Vorrichtung (101, 200) bildet, und ein erstes Trägerelement (220), das mit der festen Abdeckung (211) gekoppelt ist, und
wobei das Sensorsubstrat (260) auf dem ersten Trägerelement (220) angeordnet ist.

9. Elektronische Vorrichtung (101, 200) nach Anspruch 8,
wobei das Sensorsubstrat (260) eine erste Fläche (261), die mit dem ersten Trägerelement (220) gekoppelt ist, und eine zweite Fläche (263), auf der die Erfassungspolster (280) angeordnet sind, umfasst, wobei die zweite Fläche (263) so konfiguriert ist, dass sie von der ersten Fläche (261) abgewandt ist, und
wobei das Sensorsubstrat (260) so angeordnet ist, dass die erste Fläche (261) und die zweite Fläche (263) senkrecht zu der Vorderseite oder der Rückseite der elektronischen Vorrichtung (101, 200) sind.

10. Elektronische Vorrichtung (101, 200) nach Anspruch 8,
wobei das zweite Gehäuse (230) eine gleitende Abdeckung (231), die in einem Innenraum der festen Abdeckung (211) gleitend angeordnet ist, und ein zweites Trägerelement (240) beinhaltet, das mit der gleitenden Abdeckung (231) gekoppelt ist, so dass es sich einstückig mit der gleitenden Abdeckung (231) bewegt, und
wobei die leitfähige Walze (270) auf dem zweiten Trägerelement (240) angeordnet ist.

11. Elektronische Vorrichtung (101, 200) nach Anspruch 10,
wobei die leitfähige Walze (270) mit dem zweiten Trägerelement (240) gekoppelt ist, so dass sie um eine Drehachse drehbar ist, und
wobei sich die Drehachse in einer Richtung senkrecht zur ersten Richtung (D1) und zur zweiten Richtung (D2) erstreckt.

12. Elektronische Vorrichtung (101, 200) nach Anspruch 1, ferner umfassend:
einen oder mehrere Prozessoren (120), die betriebsfähig mit einer Vielzahl von Positionspolstern (281) verbunden sind, die die Vielzahl der Erfassungspolster (280) umfassen,
einen Speicher (130), der ein oder mehrere Computerprogramme (140) speichert, die computerausführbare Anweisungen beinhalten, die, wenn sie von dem einen oder den mehreren Prozessoren (120) ausgeführt werden, die elektronische Vorrichtung (101, 200) veranlassen zum:
Erfassen eines Kontakts zwischen der leitfähigen Walze (270) und der Vielzahl von Positionspolstern (281), und
Bestimmen einer Position der leitfähigen Walze (270) basierend auf der vom Kontakt erkannten Spannung und einer Änderung der Spannung.

13. Elektronische Vorrichtung (101, 200) nach Anspruch 12, ferner umfassend:
ein Antriebselement (293), das konfiguriert ist, um das zweite Gehäuse (230) relativ zum ersten Gehäuse (210) zu bewegen,
wobei das Antriebselement (293) einen Motor (296) beinhaltet, der betriebsfähig mit dem Prozessor (120) verbunden ist, und
wobei das eine oder die mehreren Computerprogramme (140) ferner computerausführbare Anweisungen umfassen zum:
Erfassen (310) eines Auslösevorgangs zur Änderung eines Zustands der elektronischen Vorrichtung (101, 200),
Erkennen (320) eines Teils der Vielzahl von Positionspolstern (281) als Zielpolster (280) als Reaktion auf den erfassten Auslösevorgang,
Bewegen (330) des zweiten Gehäuses (230) durch Antreiben des Motors (296), so dass die leitfähige Walze (270) in Kontakt mit dem Zielpolster (280) gebracht wird, und
Erfassen (340) des Kontakts zwischen der leitfähigen Walze (270) und dem Zielpolster (280).

14. Elektronische Vorrichtung (101, 200) nach Anspruch 13,
wobei die Erfassungspolster (280) ferner ein oder mehrere Vorpositionierungspolster (282) beinhalten, die an Positionen angeordnet sind, die von der Vielzahl von Positionspolstern (281) um einen ersten Abstand in mindestens einer der ersten Richtung (D1) oder der zweiten Richtung (D2) beabstandet sind,
wobei das eine oder die mehreren Vorpositionierungspolster (282) betriebsfähig mit dem Prozessor (120) verbunden sind, und
wobei das eine oder die mehreren Computerprogramme (140) ferner computerausführbare Anweisungen umfassen zum:
Vergleichen (450) der erwarteten Zeit, die die leitfähige Walze (270) benötigt, um mit einem benachbarten, dem Zielpolster (280) entsprechenden Vorpositionierungspolster (282) in Kontakt zu kommen, mit der tatsächlich verbrachten Kontaktzeit,
Kompensieren (470) eines Bewegungsabstands durch Differenz, indem der Antrieb des Motors (296) gesteuert wird, wenn (460) eine Differenz zwischen der erwarteten Zeit und der Kontaktzeit innerhalb eines ersten Bereichs liegt, und
Antreiben (490) in einem anormalen Fall, wenn die Differenz zwischen der erwarteten Zeit und der Kontaktzeit den ersten Bereich überschreitet.

15. Elektronische Vorrichtung (101, 200) nach Anspruch 14, wobei das eine oder die mehreren Computerprogramme (140) beim Antreiben (490) in dem anormalen Fall ferner computerausführbare Anweisungen umfassen zum:
Erfassen (492), ob die leitfähige Walze (270) mit dem benachbarten Vorpositionierungspolster (282) in Kontakt kommt,
Antreiben (495) des Motors (296), so dass die leitfähige Walze (270) in Kontakt mit dem benachbarten Vorpositionierungspolster (282) gebracht wird, wenn der Kontakt zwischen der leitfähigen Walze (270) und dem benachbarten Vorpositionierungspolster (282) nicht erfasst wird, und
Bewegen (497) der leitfähigen Walze (270) um den ersten Abstand, basierend darauf, dass der Kontakt zwischen der leitfähigen Walze (270) und dem benachbarten Vorpositionierungspolster (282) erfasst wird (496).

## Revendications

1. Dispositif électronique (101, 200), comprenant :
un premier boîtier (210) ;
un deuxième boîtier (230) couplé au premier boîtier (210) de manière à coulisser dans une première direction (D1) et dans une seconde direction (D2) opposée à la première direction (D1) ;
un affichage flexible (250) comprenant une région exposée sur une surface avant du dispositif électronique (101, 200), la région exposée étant de taille variable en réponse au coulissement du second boîtier (230) ;
un substrat de détection (260) disposé dans le premier boîtier (210) ; et
un rouleau conducteur (270) disposé dans le second boîtier (230) de manière à être rotatif,
dans lequel une pluralité de plots de détection (280) sont disposés sur une surface du substrat de détection (260) et sont disposés à des positions correspondant à une pluralité d'états du dispositif électronique,
dans lequel le rouleau conducteur (270) est configuré pour se déplacer par rapport au substrat de détection (260) lorsque le second boîtier (230) glisse par rapport au premier boîtier (210),
dans lequel le rouleau conducteur (270) est configuré pour entrer en contact direct avec une partie de la pluralité de plots de détection (280) tout en se déplaçant sur le substrat de détection (260) et provoquer une modification de la tension connectée aux plots de détection contactés (280).

2. Dispositif électronique (101, 200) de la revendication 1,
dans lequel le dispositif électronique (101, 200) passe à la pluralité d'états dans lesquels la région exposée de l'affichage flexible (250) a des tailles différentes, sur la base du coulissement du second boîtier (230),
dans lequel la pluralité d'états du dispositif électronique (101, 200) comprend :
un premier état (S1) dans lequel la région exposée présente une première taille,
un second état (S2) dans lequel la région exposée présente une seconde taille supérieure à la première taille, et
un troisième état (S3) dans lequel la région exposée présente une troisième taille supérieure à la première taille et inférieure à la seconde taille,
dans lequel la pluralité de plots de détection (280) comprend une pluralité de plots de position (281) configurés pour entrer en contact avec le rouleau conducteur (270) dans un état dans lequel la région exposée de l'affichage flexible (250) est formée dans une ou plusieurs tailles spécifiées, et
dans lequel la pluralité de plots de position (281) comprend :
un premier ensemble de plots (281a) mis en contact avec le rouleau conducteur (270) dans le premier état (S1),
un second ensemble de plots (281b) mis en contact avec le rouleau conducteur (270) dans le second état (S2), et
un troisième ensemble de plots (281c) mis en contact avec le rouleau conducteur (270) dans le troisième état (S3).

3. Dispositif électronique (101, 200) de la revendication 2, dans lequel le premier ensemble de plots (281a), le second ensemble de plots (281b), et le troisième ensemble de plots (281c) sont disposés séquentiellement sur l'une surface du substrat de détection (260) dans la première direction (D1).

4. Dispositif électronique (101, 200) de la revendication 3,
dans lequel la pluralité d'états du dispositif électronique (101, 200) comprend en outre un quatrième état (S4) dans lequel la région exposée présente une quatrième taille supérieure à la troisième taille et inférieure à la seconde taille, et
dans lequel la pluralité de plots de position (281) comprend en outre un quatrième ensemble de plots (281d) mis en contact avec le rouleau conducteur (270) dans le quatrième état (S4) et disposé entre le troisième ensemble de plots (281c) et le second ensemble de plots (281b).

5. Dispositif électronique (101, 200) de la revendication 2,
dans lequel les plots de détection (280) comprennent en outre un ou plusieurs plots de prépositionnement (282) disposés entre la pluralité de plots de position (281) situés de manière adjacente les uns aux autres, et
dans lequel le ou les plots de prépositionnement (282) sont espacés de la pluralité de plots de position (281) d'une distance spécifiée.

6. Dispositif électronique (101, 200) de la revendication 5, dans lequel le ou les plots de prépositionnement (282) comprennent :
un premier ensemble de pré-plots (282a) disposé à une position espacée du premier ensemble de plots (281a) d'une première distance dans la première direction (D1) ;
un second ensemble de pré-plots (282e) disposé à une position espacée du second ensemble de plots (281b) de la première distance dans la seconde direction (D2) ; et
un troisième ensemble de pré-plots (282b) disposé à une position espacée du troisième ensemble de plots (281c) de la première distance dans la première direction (D1).

7. Dispositif électronique (101, 200) de la revendication 6, dans lequel le premier ensemble de pré-plots (282a) est disposé à une position espacée du troisième ensemble de plots (281c) de la première distance dans la seconde direction (D2).

8. Dispositif électronique (101, 200) de la revendication 1,
dans lequel le premier boîtier (210) comprend un couvercle fixe (211) configuré pour former au moins une partie des surfaces latérales et arrière du dispositif électronique (101, 200) et un premier élément de support (220) couplé au couvercle fixe (211), et
dans lequel le substrat de détection (260) est disposé sur le premier élément de support (220).

9. Dispositif électronique (101, 200) de la revendication 8,
dans lequel le substrat de détection (260) comprend une première surface (261) couplée au premier élément de support (220) et une seconde surface (263) sur laquelle sont disposées les plots de détection (280), la seconde surface (263) étant configurée pour faire face à l'opposé de la première surface (261), et
dans lequel le substrat de détection (260) est disposé de telle sorte que la première surface (261) et la seconde surface (263) sont perpendiculaires à la surface avant ou à la surface arrière du dispositif électronique (101, 200).

10. Dispositif électronique (101, 200) de la revendication 8,
dans lequel le second boîtier (230) comprend un couvercle coulissant (231) disposé dans un espace intérieur du couvercle fixe (211) de manière à glisser et un second élément de support (240) couplé au couvercle coulissant (231) de manière à se déplacer intégralement avec le couvercle coulissant (231), et
dans lequel le rouleau conducteur (270) est disposé sur le second élément de support (240).

11. Dispositif électronique (101, 200) de la revendication 10,
dans lequel le rouleau conducteur (270) est couplé au second élément de support (240) de manière à être rotatif autour d'un axe de rotation, et
dans lequel l'axe de rotation s'étend dans une direction perpendiculaire à la première direction (D1) et à la seconde direction (D2).

12. Dispositif électronique (101, 200) de la revendication 1, comprenant en outre :
un ou plusieurs processeurs (120) connectés de manière opérationnelle à une pluralité de plots de position (281) comprenant la pluralité de plots de détection (280),
une mémoire (130) stockant un ou plusieurs programmes informatiques (140) comprenant des instructions exécutables par ordinateur qui, lorsqu'elles sont exécutées par le ou les processeurs (120), amènent le dispositif électronique (101, 200) à :
détecter le contact entre le rouleau conducteur (270) et la pluralité de plots de position (281), et
déterminer une position du rouleau conducteur (270) en se basant sur la tension reconnue par le contact et une variation de la tension.

13. Dispositif électronique (101, 200) de la revendication 12, comprenant en outre :
un élément d'entraînement (293) configuré pour déplacer le second boîtier (230) par rapport au premier boîtier (210),
dans lequel l'élément d'entraînement (293) comprend un moteur (296) connecté de manière opérationnelle au processeur (120), et
dans lequel le ou les programmes informatiques (140) comprennent en outre des instructions exécutables par ordinateur visant à :
détecter (310) une opération de déclenchement pour changer un état du dispositif électronique (101, 200),
détecter (320) une partie de la pluralité de plots de position (281) en tant que plot cible (280) en réponse à l'opération de déclenchement détectée,
déplacer (330) le second boîtier (230) en entraînant le moteur (296) de manière à ce que le rouleau conducteur (270) soit mis en contact avec le plot cible (280), et
détecter (340) le contact entre le rouleau conducteur (270) et le plot cible (280).

14. Dispositif électronique (101, 200) de la revendication 13,
dans lequel les plots de détection (280) comprennent en outre un ou plusieurs plots de prépositionnement (282) disposés à des positions espacées de la pluralité de plots de position (281) d'une première distance dans au moins l'une de la première direction (D1) ou de la seconde direction (D2),
dans lequel le ou les plots de prépositionnement (282) sont connectés de manière opérationnelle au processeur (120), et
dans lequel le ou les programmes informatiques (140) comprennent en outre des instructions exécutables par ordinateur visant à :
comparer (450) le temps prévu pour que le rouleau conducteur (270) entre en contact avec un plot de prépositionnement adjacente (282) correspondant au plot cible (280) et le temps de contact réel,
compenser (470) une distance de déplacement par différence en commandant l'entraînement du moteur (296) lorsque (460) une différence entre le temps prévu et le temps de contact se situe dans une première plage, et
entraîner (490) dans un cas anormal, lorsque la différence entre le temps prévu et le temps de contact dépasse la première plage.

15. Dispositif électronique (101, 200) de la revendication 14, dans lequel, lors de l'entraînement (490) dans le cas anormal, le ou les programmes informatiques (140) comprennent en outre des instructions exécutables par ordinateur pour :
détecter (492) si le rouleau conducteur (270) entre en contact avec le plot de prépositionnement adjacente (282),
entraîner (495) le moteur (296) de manière à ce que le rouleau conducteur (270) soit mis en contact avec le plot de prépositionnement adjacent (282), lorsque le contact entre le rouleau conducteur (270) et le plot de prépositionnement adjacent (282) n'est pas détecté, et
déplacer (497) le rouleau conducteur (270) de la première distance, en se basant sur la détection (496) du contact entre le rouleau conducteur (270) et le plot de prépositionnement adjacent (282).
